# EUROPEAN PATENT APPLICATION

(11) **EP 4 513 565 A1**
(43) Date of publication of application: **26.02.2025**
(21) Application number: 22938608.1
(22) Date of filing: 07.12.2022
(51) Int. Cl.: H01L 27/146

(54) **OPTICAL DETECTION DEVICE**

(30) Priority: 18.04.2022 JP 2022068494
(71) Applicant: Sony Semiconductor Solutions Corporation, Atsugi-shi, Kanagawa 243-0014 (JP)
(72) Inventor: SUGIMOTO, Masataka, Atsugi-shi, Kanagawa 243-0014 (JP); MIZUTA, Kyohei, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/045159
(87) International publication number: WO 2023/203811

(57) **Abstract**

To suppress diffusion of impurities from a pixel boundary side to a photoelectric conversion unit, and improve a degree of freedom in electric field design of the photoelectric conversion unit.

A photodetection device includes: a plurality of photoelectric conversion units provided for each pixel and disposed in a silicon layer; and a polysilicon layer and an insulating layer that are stacked in a depth direction of the plurality of photoelectric conversion units from a surface side opposite to a light incident surface of the plurality of photoelectric conversion units along a boundary region of the plurality of photoelectric conversion units, in which an interface between the polysilicon layer and the insulating layer has a convex shape in a direction of the light incident surface.

## Description

### TECHNICAL FIELD

The present disclosure relates to a photodetection device.

### BACKGROUND ART

In a boundary region of pixels of a photodetection device such as an image sensor, an element isolation region called a shallow trench isolation (STI) layer may be provided (see Patent Document 1).

### CITATION LIST

### PATENT DOCUMENT

Patent Document 1: Japanese Patent Application Laid-Open No. 2018-148116

### SUMMARY OF THE INVENTION

### PROBLEMS TO BE SOLVED BY THE INVENTION

Furthermore, a plurality of pixels may share a floating diffusion layer (floating gate). In this case, it is conceivable to provide the floating diffusion layer in the boundary region of the plurality of pixels. Since a charge from a transfer electrode is transferred to the floating diffusion layer, it is desired that the floating diffusion layer has an element structure capable of efficiently transferring the charge.

Furthermore, a light shielding member or the like may be disposed in the boundary region of pixels in order to prevent incidence of light from an adjacent pixel. Moreover, it is also necessary to take measures to prevent generation of dark current in the boundary region.

As described above, to dispose the floating diffusion layer in the boundary region of pixels, it is necessary to consider efficient charge transfer from the transfer electrode, color mixture suppression, dark current suppression, and the like.

Therefore, the present disclosure provides a photodetection device capable of efficiently transferring charges from a transfer electrode, suppressing color mixture, and suppressing dark current.

### SOLUTIONS TO PROBLEMS

To solve the above-described problems, according to the present disclosure, there is provided a photodetection device including:
a plurality of photoelectric conversion units provided for each pixel and disposed in a silicon layer; and
a polysilicon layer and an insulating layer stacked in a depth direction of the plurality of photoelectric conversion units from a surface side opposite to a light incident surface of the plurality of photoelectric conversion units along a boundary region of the plurality of photoelectric conversion units, in which
at least a part of the polysilicon layer is disposed so as to be in contact with the silicon layer.

The polysilicon layer may have a step portion in contact with the silicon layer.

The step portion may be disposed along an end surface of the silicon layer on the surface side opposite to the light incident surface.

The step portion may be disposed on a side closer to the light incident surface than an end surface of the silicon layer on the surface side opposite to the light incident surface.

A sidewall surface of the polysilicon layer and a sidewall surface of the insulating layer may be disposed so as to be in contact with the silicon layer.

An interface between the polysilicon layer and the insulating layer may have a convex shape in a direction of the light incident surface.

A part of the polysilicon layer may be covered with the insulating layer at the interface.

The polysilicon layer may have a step portion or a convex surface portion in the direction of the light incident surface at the interface.

The polysilicon layer may include
a first region in contact with the silicon layer, and
a second region bonded to the first region and disposed closer to a light incident surface side than the first region, in which
the insulating layer may be disposed between the second region and the silicon layer.

The polysilicon layer may have a protrusion extending to a side of the insulating layer at the interface, and
an end portion of the protrusion on the light incident surface side may be disposed inside the insulating layer.

The insulating layer may be disposed between a sidewall portion of the protrusion and the silicon layer.

A length of the protrusion from the interface to the side of insulating layer may be 10 nm or more.

A width of the insulating layer disposed between a sidewall portion of the protrusion and the photoelectric conversion unit may be 20 nm or more.

The polysilicon layer may be a conductive layer in conduction with a ground layer or a floating diffusion layer.

Two of the polysilicon layers may be provided for each of the pixels, and
one of the polysilicon layers may be in conduction with the ground layer, and
the other polysilicon layer may be in conduction with the floating diffusion layer.

Each of the two polysilicon layers may be shared by a plurality of pixels.

The floating diffusion layer may be disposed in a boundary region of a first pixel group including a plurality of pixels and shared by the first pixel group, and
the ground layer may be disposed in a boundary region of a second pixel group including a plurality of pixels different from the first pixel group and shared by the second pixel group.

The pixel may include a phase difference detection pixel that detects a phase difference, and
the floating diffusion layer may be shared by a plurality of the phase difference detection pixels that detects a phase difference.

A transfer electrode disposed along an end surface of the silicon layer on the surface side opposite to the light incident surface, and configured to transfer a charge photoelectrically converted by the photoelectric conversion unit to the floating diffusion layer; and
a vertical electrode extending from the transfer electrode in a depth direction of the silicon layer may be further provided, and
the transfer electrode and the vertical electrode may include a sidewall portion including an insulating material disposed along a sidewall surface of the polysilicon layer.

An impurity diffusion region disposed inside the silicon layer from the sidewall surface of the polysilicon layer in the boundary region may be further included, and
the sidewall portion may be disposed to face the impurity diffusion region.

A plurality of the vertical electrodes may be provided for each of the pixels.

A boundary layer including a semiconductor or a conductor and stacked on a light incident surface side of the insulating layer along the boundary region of the plurality of photoelectric conversion units may be further included, and
a plane orientation in an extending direction of the boundary layer and a plane orientation in an extending direction of the vertical electrode may be (100) planes.

A boundary layer including a semiconductor or a conductor stacked on a light incident surface side of the insulating layer along the boundary region of the plurality of photoelectric conversion units may be further included.

The boundary layer may include a polysilicon layer or a fixed charge layer.

The boundary layer may be a negative bias layer that induces a positive charge.

The boundary region may be disposed so as to penetrate the silicon layer, and
the boundary region may have a structure in which the boundary layer, the insulating layer, and the polysilicon layer are stacked in this order from the light incident surface side to the surface side opposite to the light incident surface side.

### BRIEF DESCRIPTION OF DRAWINGS

Fig. 1 is a diagram illustrating a schematic configuration of a photodetection device 1 to which the present technology is applied.
Fig. 2 is a diagram illustrating an equivalent circuit of a pixel 2.
Fig. 3 is a schematic plan view of the pixel 2 in a pixel array unit 3.
Fig. 4 is a cross-sectional view of one pixel 2 of the photodetection device 1 according to a present embodiment.
Fig. 5 is a cross-sectional view of the pixel 2 according to a comparative example.
Fig. 6 is a plan view near a bonding place between a polysilicon layer 31 and an STI layer 32 in Figs. 4 and 5.
Fig. 7A is a cross-sectional view taken along line A-A in Fig. 6 in the pixel 2 in Fig. 4.
Fig. 7B is a cross-sectional view taken along line B-B in Fig. 6 in the pixel 2 in Fig. 4.
Fig. 8A is a cross-sectional view taken along line A-A in Fig. 6 in the pixel 2 in Fig. 5.
Fig. 8B is a cross-sectional view taken along line B-B in Fig. 6 in the pixel 2 in Fig. 5.
Fig. 9A is a plan view according to a first specific example.
Fig. 9B is a cross-sectional view taken along line A-A in Fig. 9A.
Fig. 9C is a cross-sectional view taken along line B-B in Fig. 9A.
Fig. 10A is a plan view according to a second specific example.
Fig. 10B is a cross-sectional view taken along line A-A in Fig. 10A.
Fig. 10C is a cross-sectional view taken along line B-B in Fig. 10A.
Fig. 11A is a plan view according to a third specific example.
Fig. 11B is a cross-sectional view taken along line A-A in Fig. 11A.
Fig. 11C is a cross-sectional view taken along line B-B in Fig. 11A.
Fig. 12A is a plan view according to a fourth specific example.
Fig. 12B is a cross-sectional view taken along line A-A in Fig. 12A.
Fig. 12C is a cross-sectional view taken along line B-B in Fig. 12A.
Fig. 13 is a table comparing a comparative example illustrated in Figs. 8A and 8B with the first to fourth specific examples illustrated in Figs. 9A to 12C.
Fig. 14 is a cross-sectional view of the pixel 2 including a boundary layer 33 having a fixed charge layer 35.
Fig. 15 is a cross-sectional view illustrating an example in which an end portion of a protrusion 31p extends to a vicinity of a boundary region between the STI layer 32 and the boundary layer 33.
Fig. 16A is a view illustrating an example in which the boundary layer 33 includes a polysilicon layer 34.
Fig. 16B is a view illustrating an example in which the boundary layer 33 includes the fixed charge layer 35.
Fig. 17 is a cross-sectional view of one pixel of a photodetection device according to a second embodiment.
Fig. 18 is a cross-sectional view of one pixel of a photodetection device 1 according to a modification of the second embodiment.
Fig. 19 is a table illustrating characteristics of representative shapes of the photodetection device according to the second embodiment.
Fig. 20A is a view illustrating a cross-sectional structure of a boundary region according to first and second comparative examples.
Fig. 20B is a view illustrating a cross-sectional structure of a boundary region according to first and second specific examples.
Fig. 20C is a view illustrating a cross-sectional structure of a boundary region according to third and fourth specific examples.
Fig. 21A is a plan view of the boundary region according to the first comparative example.
Fig. 21B is a plan view of the boundary region according to the second comparative example, the second specific example, and the fourth specific example.
Fig. 21C is a plan view of the boundary region according to the first specific example and the third specific example.
Fig. 22 is a cross-sectional view of one pixel of a photodetection device according to a third embodiment.
Fig. 23 is a cross-sectional view of a pixel according to a comparative example.
Fig. 24 is a cross-sectional view of a pixel prepared by forming a trench from a light incident surface side.
Fig. 25 is a cross-sectional view of a pixel according to a comparative example.
Fig. 26 is a cross-sectional view of a pixel according to a modification of Fig. 24.
Fig. 27 is a table summarizing characteristics of a plurality of representative specific examples of a vertical electrode.
Fig. 28 is a table summarizing characteristics of a plurality of representative modifications of a vertical electrode.
Fig. 29A is a plan view of a pixel 2 according to a fifth modification.
Fig. 29B is a plan view of a pixel 2 according to a sixth modification.
Fig. 30A is a cross-sectional view of one pixel of a photodetection device according to a fourth embodiment.
Fig. 30B is a cross-sectional view of a pixel according to a modification of Fig. 30A.
Fig. 31 is a block diagram illustrating an example of a schematic configuration of a vehicle control system.
Fig. 32 is an explanatory view illustrating an example of installation positions of an outside-vehicle information detecting section and an imaging section.

### MODE FOR CARRYING OUT THE INVENTION

Hereinafter, embodiments of a photodetection device will be described with reference to the drawings. Hereinafter, main components of the photodetection device will be mainly described, but the photodetection device may have configuration portions and functions that are not illustrated or described. The following description does not exclude components and functions that are not illustrated or described.

### (Schematic Configuration Example of Photodetection Device)

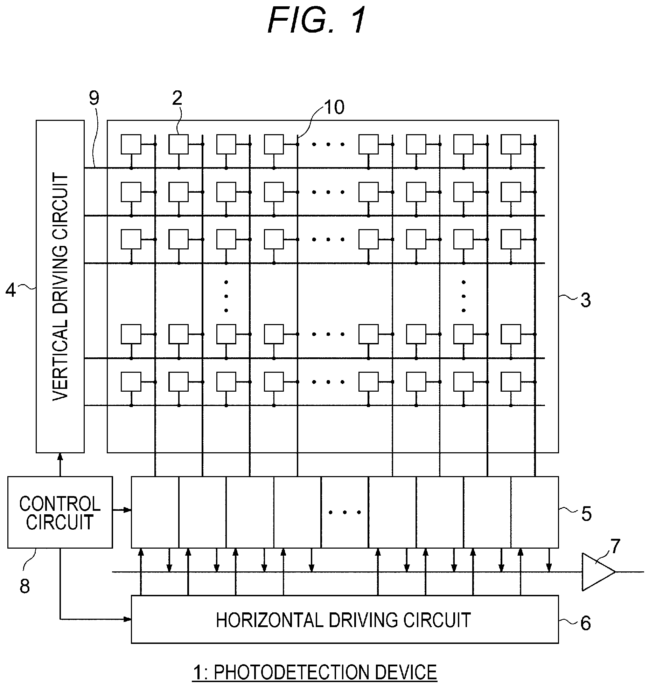

Fig. 1 is a diagram illustrating a schematic configuration of a photodetection device 1 to which the present technology is applied. The photodetection device 1 of Fig. 1 may be referred to as an imaging device or an image sensor.

The photodetection device 1 of Fig. 1 has a configuration in which a pixel array unit 3 having pixels 2 disposed in a two-dimensional array and a peripheral circuit unit around the pixel array unit 3 are disposed on a semiconductor substrate using, for example, silicon (Si) as a semiconductor. The peripheral circuit unit includes a vertical driving circuit 4, a column signal processing circuit 5, a horizontal driving circuit 6, an output circuit 7, a control circuit 8, and the like.

The pixel 2 includes a photodiode as a photoelectric conversion element, a plurality of pixel transistors and the like. The plurality of pixel transistors includes four MOS transistors, which are a transfer transistor, a selection transistor, a reset transistor, and an amplification transistor, for example. Note that a configuration to omit the transfer transistor, a configuration to add a pixel transistor for another application, or the like is conceivable as the pixel transistor, and the type of the pixel transistor is not uniquely limited.

The control circuit 8 receives an input clock and data instructing an operation mode, and outputs data such as internal information of the photodetection device 1. That is, the control circuit 8 generates a clock signal and a control signal that serve as a reference for operation of the vertical driving circuit 4, the column signal processing circuit 5, the horizontal driving circuit 6, and the like on the basis of a vertical synchronization signal, a horizontal synchronization signal, and a master clock. Then, the control circuit 8 outputs the generated clock signal and control signal to the vertical driving circuit 4, the column signal processing circuit 5, the horizontal driving circuit 6, and the like.

The vertical driving circuit 4 includes, for example, a shift register, selects predetermined pixel driving wiring 9, supplies a pulse for driving the pixel 2 to the selected pixel driving wiring 9, and drives the pixels 2 in units of rows. That is, the vertical driving circuit 4 selectively scans each pixel 2 of the pixel array unit 3 sequentially in a vertical direction in units of rows. Therefore, a pixel signal based on a signal charge generated according to the amount of received light by a photoelectric conversion unit of each pixel 2 is supplied to the column signal processing circuit 5 through a vertical signal line 10.

The column signal processing circuit 5 disposed for each column of the pixels 2 performs signal processing such as noise removal on the signals output from the pixels 2 of one column for each pixel column. For example, the column signal processing circuit 5 performs signal processing such as correlated double sampling (CDS) for removing pixel-specific fixed pattern noise, AD conversion and the like.

The horizontal driving circuit 6 including a shift register, for example, sequentially selects each of the column signal processing circuits 5 by sequentially outputting horizontal scanning pulses and outputs the pixel signal from each of the column signal processing circuits 5 to a horizontal signal line 11.

The output circuit 7 performs signal processing for the signals sequentially supplied from each of the column signal processing circuits 5 through a horizontal signal line 11 and outputs the processed signals. Note that, in the output circuit 7, for example, there is a case where only buffering is performed, or a case where black level adjustment, column variation correction, various kinds of digital signal processing, and the like are performed. An input/output terminal 13 communicates signals with an outside.

The photodetection device 1 configured as described above is a CMOS image sensor referred to as a column AD type in which the column signal processing circuit 5 that performs CDS processing and AD conversion processing is disposed for each pixel column.

Furthermore, the photodetection device 1 also is a back-illuminated MOS photodetection device 1 on which light is incident from a back surface side on a side opposite to a front surface of a semiconductor substrate 12 on which the pixel transistors are formed.

### (Circuit Configuration Example of Pixel 2)

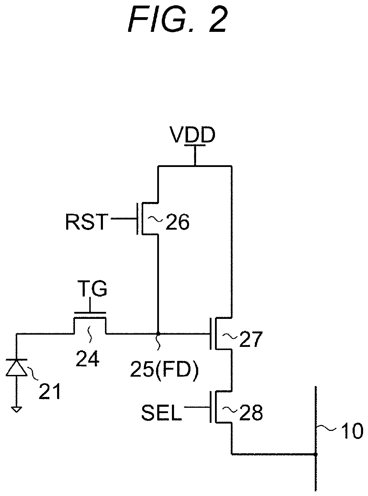

Fig. 2 is a diagram illustrating an equivalent circuit of the pixel 2. The pixel 2 includes a photoelectric conversion unit (photodiode) 21, a transfer transistor 24, a floating diffusion layer (floating diffusion) 25, a reset transistor 26, an amplification transistor 27, and a selection transistor 28.

The photoelectric conversion unit 21 is a photoelectric conversion unit (photoelectric conversion region) that generates and accumulates a charge (signal charge) corresponding to the amount of received light. An anode terminal of the photoelectric conversion unit 21 is grounded, and a cathode terminal is connected to the floating diffusion layer 25 via the transfer transistor 24.

When turned on by a transfer signal TR, the transfer transistor 24 reads the charge generated by the photoelectric conversion unit 21 and transfers the charge to the floating diffusion layer 25.

The floating diffusion layer 25 is a charge holding unit that holds the charge read from the photoelectric conversion unit 21. When turned on by a reset signal RST, the reset transistor 26 resets a potential of the floating diffusion layer 25 by discharging the charge held in the floating diffusion layer 25 to a constant voltage source Vdd.

The amplification transistor 27 outputs the pixel signal corresponding to the potential of the floating diffusion layer 25. That is, the amplification transistor 27 configures a source follower circuit together with a load MOS (not illustrated) as a constant current source. The pixel signal indicating a level corresponding to the charge held in the floating diffusion layer 25 is output from the amplification transistor 27 to the column signal processing circuit 5 (Fig. 1) via the selection transistor 28.

The selection transistor 28 is turned on when the pixel 2 is selected by a selection signal SEL, and outputs the pixel signal of the pixel 2 to the column signal processing circuit 5 via the vertical signal line 10. The transfer signal TR, the reset signal RST, and the selection signal SEL are controlled by the vertical driving circuit 4 and supplied via the pixel driving wiring 9 (Fig. 1).

### (First Embodiment)

A polysilicon layer may be stacked on an STI layer along a boundary region of a pixel. Impurities are dosed to the polysilicon layer for making the layer conductive. A part of the dosed impurities is diffused from the polysilicon layer to a photoelectric conversion unit to form a diffusion capacitance. The amount of impurities diffused into the photoelectric conversion unit depends on a volume of the polysilicon layer.

The above-described diffusion capacitance causes a change in photoelectric conversion efficiency and affects an electric field in the photoelectric conversion unit. For example, the larger the diffusion capacitance, the smaller the photoelectric conversion efficiency and the steeper the electric field in the photoelectric conversion unit. When the electric field in the photoelectric conversion unit becomes steep due to diffusion of impurities, it becomes difficult to design the electric field of the photoelectric conversion unit.

Therefore, the first embodiment is characterized in suppressing diffusion of impurities from a pixel boundary side to the photoelectric conversion unit, and improving the degree of freedom in electric field design of the photoelectric conversion unit.

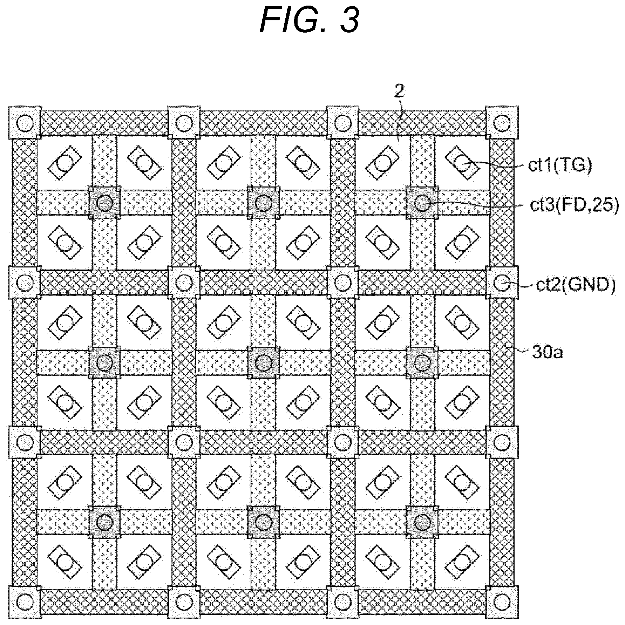

Fig. 3 is a schematic plan view of pixels 2 in a pixel array unit 3 of a photodetection device 1 according to the first embodiment. The circles in Fig. 3 represent contacts ct1, ct2, and ct3. In a region of the pixel 2, only one contact ct1 connected to a gate (hereinafter, transfer gate TG) of a transfer transistor 24 is illustrated. Actually, there may be a plurality of contacts connected to the gates and the like of other pixel transistors 20, but these contacts are omitted in Fig. 3.

In the example of Fig. 3, four adjacent pixels 2 share one floating diffusion layer 25. The four pixels 2 sharing the floating diffusion layer 25 may be referred to as color pixels. The four pixels 2 may be, for example, a Bayer array including two green pixels, one red pixel, and one blue pixel. Note that the number of pixels 2 sharing one floating diffusion layer 25 is not necessarily four, and may be, for example, two. Furthermore, a separate floating diffusion layer 25 may be provided for each pixel 2.

In the example of Fig. 3, one contact ct2 for grounding is shared by four adjacent pixels 2. This is also an example, and one contact ct2 for grounding may be shared by the number of pixels 2 other than the four pixels 2, or a separate contact ct2 for grounding may be provided for each pixel 2.

As illustrated in Fig. 3, the four pixels 2 sharing the contact ct3 connected to the floating diffusion layer 25 are different from the four pixels 2 sharing the contact ct2 for grounding. That is, the floating diffusion layer 25 is disposed in a boundary region of a first pixel group including a plurality of the pixels 2 and is shared by the first pixel group, and a ground layer 30 is disposed in a boundary region of a second pixel group including a plurality of the pixels 2 different from the first pixel group and is shared by the second pixel group. Furthermore, the contacts ct2 shared by the second pixel groups are connected to each other via a conductive layer 30a to form the ground layer 30.

As illustrated in Fig. 3, in each pixel 2, the contact ct1 for the transfer gate TG and the contact ct2 for grounding are disposed in a diagonal direction of the pixel 2, and a sufficient distance between the contact ct1 for the transfer gate TG and the contact ct2 for grounding is secured. Therefore, it is possible to increase the photoelectric conversion efficiency.

Furthermore, by disposing the contacts ct1, ct3 in the diagonal direction of the pixel 2, it is possible to less easily cause variations in alignment of each of the contacts ct1 and ct3, and improve a manufacturing yield. Moreover, as illustrated in Fig. 3, by connecting the plurality of contacts ct2 for grounding by the conductive layer extending in a lattice shape, it is possible to reduce the number of contacts ct2 for grounding, and accordingly widen the degree of freedom in layout of the pixel array unit 3 and facilitate layout design.

Furthermore, a photoelectric conversion unit 21 of each pixel 2 and the pixel transistor 20 can be stacked, and the pixel transistors 20 can be further made to form a two-layer structure. In this case, it is possible to increase a semiconductor region of another layer stacked on the layer in which the transfer transistor 24 having the transfer gate TG is formed, and it is possible to increase the degree of freedom in arrangement of the pixel transistors 20 other than the transfer transistor 24.

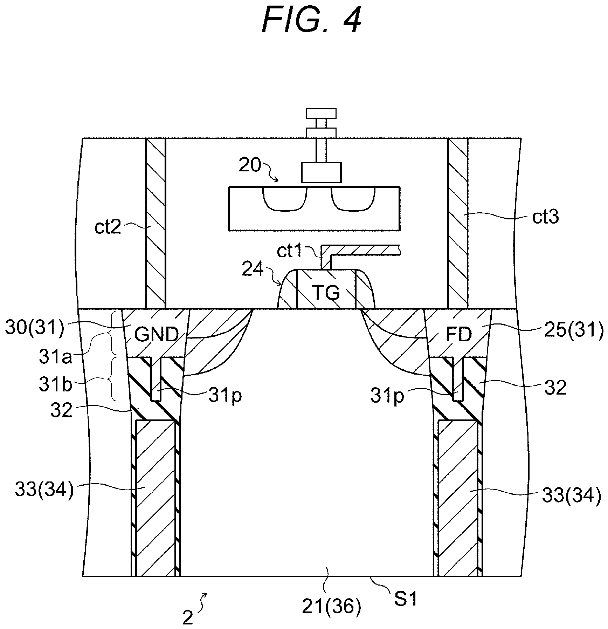

Fig. 4 is a cross-sectional view of one pixel 2 of the photodetection device 1 according to the first embodiment. Fig. 4 is a diagonal cross-sectional view of each pixel 2 in Fig. 3. An upper surface of Fig. 4 is a front surface, and a lower surface is a back surface, that is, a light incident surface S1. As described above, in the photodetection device 1 of Fig. 4, light is incident from a back surface side.

The pixel 2 in Fig. 4 has a structure in which the photoelectric conversion unit 21 and the pixel transistor 20 are stacked. The photoelectric conversion unit 21 is divided for each pixel 2 and is disposed in a silicon layer 36. In the boundary region between the adjacent pixels 2, a polysilicon layer 31 (may be referred to as a conductor layer in the present specification) and an insulating layer 32 are stacked along the boundary region.

Since the insulating layer 32 bonded to the polysilicon layer 31 and extending in a depth direction has a narrow width in a plane direction, it may be referred to as an STI layer 32 below. An interface between the polysilicon layer 31 and the STI layer 32 has a convex shape in a light incident surface S1 direction. With the convex shape, a part of the polysilicon layer 31 is covered with the STI layer 32 at the interface between the polysilicon layer 31 and the STI layer 32. The convex shape means that the polysilicon layer 31 has a step in the light incident surface S1 direction or has a convex surface portion at the interface.

In the example of Fig. 4, the polysilicon layer 31 has a protrusion 31p extending to an STI layer 32 side at the interface, and the interface has a step. An end portion of the protrusion 31p on the light incident surface S1 side is disposed inside STI layer 32. As described above, in the example of Fig. 4, the protrusion 31p protruding from the polysilicon layer 31 is disposed so as to bite into the STI layer 32. Therefore, the STI layer 32 is disposed between a sidewall portion of the protrusion 31p and the silicon layer 36 in which the photoelectric conversion unit 21 is disposed.

As described above, the polysilicon layer 31 in Fig. 4 has a first region 31a and a second region 31b along a pixel boundary region. The first region 31a is in contact with the silicon layer 36 in which the photoelectric conversion unit 21 is disposed. The second region 31b is bonded to the first region 31a and is disposed closer to the light incident surface S1 side than the first region 31a. The STI layer 32 is disposed between the second region 31b and the silicon layer 36.

The polysilicon layer 31 is a conductive layer in conduction with the ground layer 30 or the floating diffusion layer 25. Two polysilicon layers 31 are provided for each pixel 2. One polysilicon layer 31 is in conduction with the ground layer 30, and the other polysilicon layer 31 is in conduction with the floating diffusion layer 25.

The two polysilicon layers 31 provided in the pixel boundary region are shared by a plurality of pixels 2. For example, in the example of Fig. 3, the polysilicon layer 31 in conduction with the floating diffusion layer 25 is shared by the first pixel group including the four pixels 2, and the polysilicon layer 31 in conduction with the ground layer 30 is shared by the second pixel group including the four pixels 2.

As illustrated in Fig. 4, a boundary layer 33 is stacked on the light incident surface S1 side of the STI layer 32 along the boundary region of the plurality of photoelectric conversion units 21. The boundary layer 33 includes a polysilicon layer 34 or a fixed charge layer. A negative bias voltage is applied to the boundary layer 33. Thereby, a positive charge is induced on a surface of the boundary layer 33 at the time of light reception, and generation of a dark current and a white spot can be suppressed, and display quality can be improved. The boundary layer 33 is a through trench penetrating the silicon layer 36.

As will be described below, impurities are dosed to the polysilicon layer 31 on a surface side opposite to the light incident surface S1 in order to make the polysilicon layer 31 conductive. The polysilicon layer 31 in conduction with the ground layer 30 and the polysilicon layer 31 in conduction with the floating diffusion layer 25 have different types of impurities to be dosed.

When the impurities are dosed to the polysilicon layer 31, some of the dosed impurities are diffused into the silicon layer 36, and a diffusion layer is formed. The diffusion layer forms the diffusion capacitance.

In the example of Fig. 4, the transfer transistor 24 having the transfer gate TG and the other pixel transistors 20 are disposed in mutually different layers. As described above, the plurality of pixel transistors 20 is provided in the pixel 2, but an arrangement form of each pixel transistor 20 is arbitrary, and various modifications are conceivable. Furthermore, although not illustrated in Fig. 4, the photodetection device 1 having a stacked structure in which the substrate on which the pixel array unit 3 of Fig. 1 is formed and another substrate on which the vertical driving circuit 4, the column signal processing circuit 5, the horizontal driving circuit 6, the control circuit 8, and the like are formed are bonded in a stacking direction by Cu-Cu bonding or the like may be manufactured.

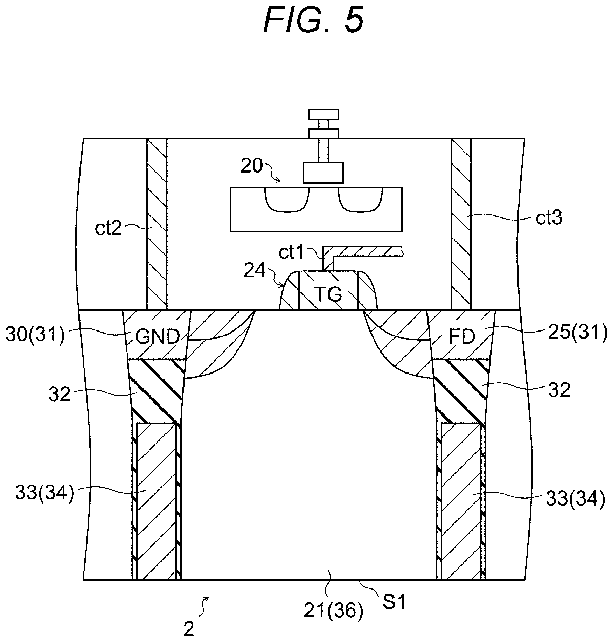

Fig. 5 is a sectional view of the pixel 2 according to a comparative example. In Fig. 5, the same components as those in Fig. 4 are denoted by the same reference numerals. In the pixel 2 in Fig. 5, the cross-sectional shape of the interface between the polysilicon layer 31 and the STI layer 32 is different from that in Fig. 4. The interface between the polysilicon layer 31 and the STI layer 32 in Fig. 5 is a flat surface, and the polysilicon layer 31 in Fig. 5 does not have the protrusion 31p as in Fig. 4. Other structures are common to Figs. 4 and 5.

In the pixel 2 according to the comparative example illustrated in Fig. 5, a volume of the polysilicon layer 31 in the pixel boundary region is smaller than that of the pixel 2 according to the present embodiment illustrated in Fig. 4. Hereinafter, the difference in volume between the polysilicon layers 31 in Figs. 4 and 5 will be described in more detail.

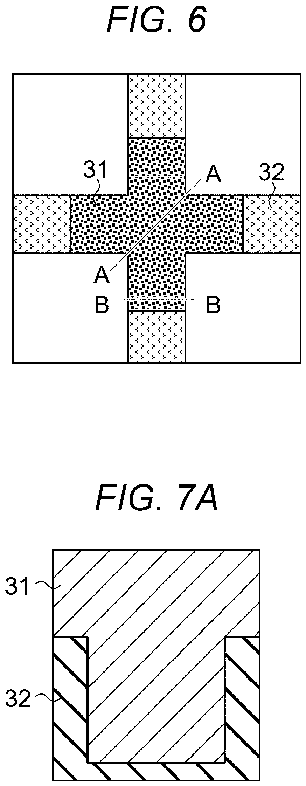

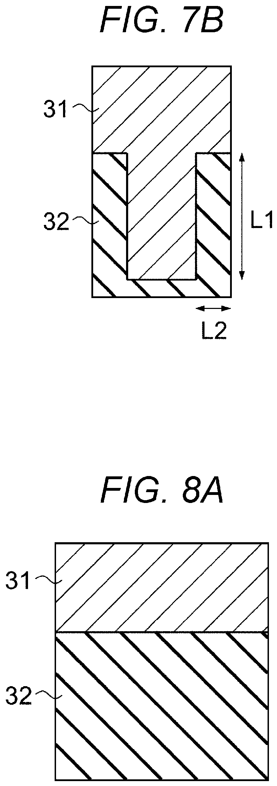

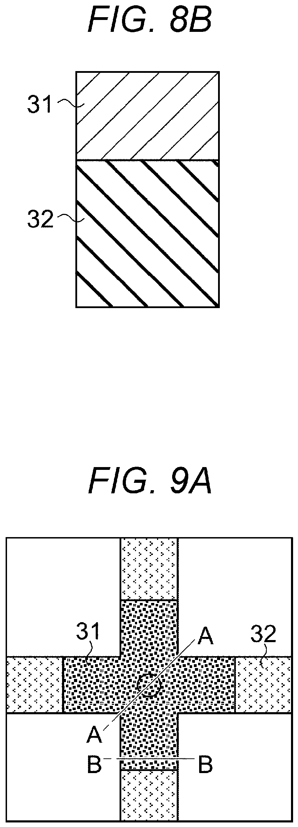

Fig. 6 is a plan view near a bonding place between the polysilicon layers 31 and the STI layer 32 in Figs. 4 and 5. Fig. 7A is a cross-sectional view taken along line A-A in Fig. 6 in the pixel 2 of Fig. 4, and Fig. 7B is a cross-sectional view taken along line B-B in Fig. 6 in the pixel 2 of Fig. 4. Furthermore, Fig. 8A is a cross-sectional view taken along line A-A in Fig. 6 in the pixel 2 of Fig. 5, and Fig. 8B is a cross-sectional view taken along line B-B in Fig. 6 in the pixel 2 of Fig. 5.

As described above, in the pixel 2 according to the comparative example, the interface between the polysilicon layer 31 and the STI layer 32 is a flat surface, whereas in the pixel 2 according to the present embodiment, the interface between the polysilicon layer 31 and the STI layer 32 has the convex shape. Therefore, the volume of the polysilicon layer 31 according to the present embodiment is larger than the volume of the polysilicon layer 31 according to the comparative example.

The polysilicon layer 31 functions as a conductor layer in conduction with the floating diffusion layer 25 or the ground layer 30. To cause the polysilicon layer 31 to function as a conductor layer, it is necessary to inject impurities into the polysilicon layer 31. The polysilicon layer 31 can incorporate more impurities therein than the STI layer 32.

In the photodetection device 1 according to the present embodiment and a photodetection device 100 according to the comparative example, the volume of the polysilicon layer 31 in the pixel boundary region is larger in the photodetection device 1 according to the present embodiment. Therefore, in the photodetection device 1 according to the present embodiment and the photodetection device 100 according to the comparative example, when the amount of impurities dosed to the polysilicon layer 31 is the same, the amount of impurities diffused from the sidewall portions of the polysilicon layer 31 and the STI layer 32 to the silicon layer 36 in which the photoelectric conversion unit 21 is disposed is larger in the photodetection device 100 according to the comparative example than the photodetection device 1 according to the present embodiment.

When the amount of impurities diffused into the silicon layer 36 increases, the diffusion capacitance increases, and the photoelectric conversion efficiency decreases. Furthermore, when the amount of impurities diffused into the silicon layer 36 increases, a change in the electric field of the silicon layer 36 becomes steep, and it becomes difficult to design the electric field of the silicon layer 36.

From the above viewpoint, it can be seen that it is desirable to increase the volume of the polysilicon layer 31 by making the interface convex rather than making the interface between the polysilicon layer 31 and the STI layer 32 flat.

Furthermore, as will be described below, even if it is attempted to flatten the interface between the polysilicon layer 31 and the STI layer 32 stacked in the pixel boundary region, the interface between the polysilicon layer 31 and the STI layer 32 may have a convex shape on the light incident surface S1 side depending on conditions of a manufacturing process or the like. In this case, the volume of the polysilicon layer 31 increases, and the amount of impurities diffused from the sidewall portions of the polysilicon layer 31 and the STI layer 32 into the silicon layer 36 where the photoelectric conversion unit 21 is disposed can be suppressed.

The shape of the interface between the polysilicon layer 31 and the STI layer 32 is not limited to those illustrated in Figs. 4, 7A, and 7B, and various shapes are conceivable.

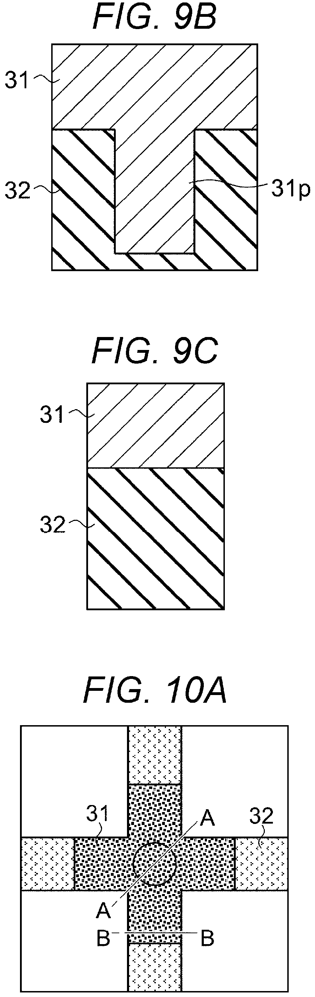

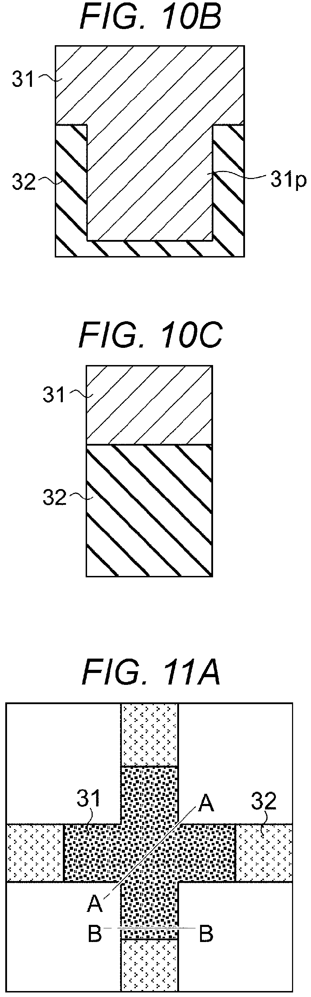

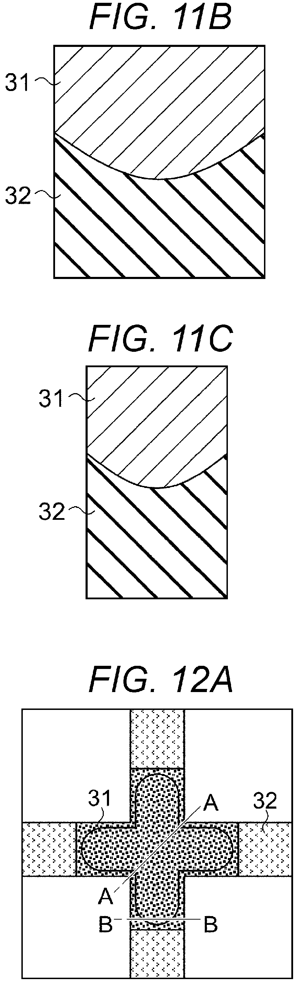

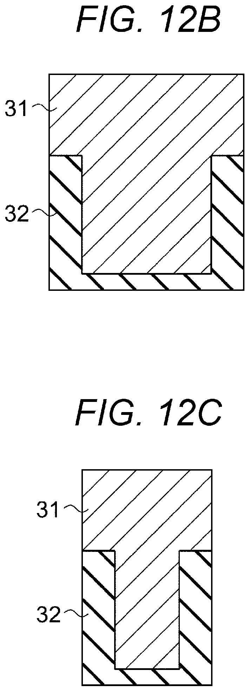

Fig. 9A is a plan view according to a first specific example, Fig. 9B is a cross-sectional view taken along line A-A in Fig. 9A, and Fig. 9C is a cross-sectional view taken along line B-B in Fig. 9A. Fig. 10A is a plan view according to a second specific example, Fig. 10B is a cross-sectional view taken along line A-A in Fig. 10A, and Fig. 10C is a cross-sectional view taken along line B-B in Fig. 10A. Fig. 11A is a plan view according to a third specific example, Fig. 11B is a cross-sectional view taken along line A-A in Fig. 11A, and Fig. 11C is a cross-sectional view taken along line B-B in Fig. 11A. Fig. 12A is a plan view according to a fourth specific example, Fig. 12B is a cross-sectional view taken along line A-A in Fig. 12A, and Fig. 12C is a cross-sectional view taken along line B-B in Fig. 12A.

As illustrated in Figs. 9B and 10B, the first specific example and the second specific example include the columnar protrusion 31p protruding from a part of the polysilicon layer 31 to the STI layer 32, and the widths of the protrusions 31p are different from each other. Specifically, the width of the protrusion 31p in the second specific example is larger than that in the first specific example. In the third specific example, as illustrated in Fig. 11B, the interface between the polysilicon layer 31 and the STI layer 32 has a convex shape. More specifically, the interface of the polysilicon layer 31 has a convex shape in the light incident surface S1 direction, and the interface of the STI layer 32 has a concave shape in the plane direction opposite to the light incident surface S1. As illustrated in Figs. 12B and 12C, the fourth specific example includes a cross-shaped protrusion 31p protruding from a part of the polysilicon layer 31 to the STI layer 32, and the cross-sectional shape of the protrusion 31p in the plane direction is a twelve square shape as illustrated in Fig. 12A. On the other hand, the cross-sectional shapes of the protrusions 31p in the first specific example and the second specific example are circular as illustrated in Figs. 9A and 10A.

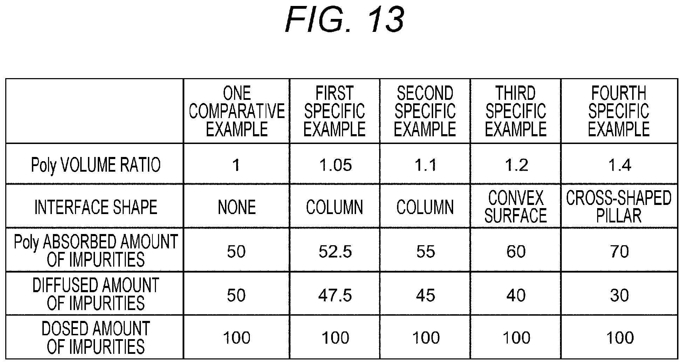

Fig. 13 is a table comparing the comparative example illustrated in Figs. 8A and 8B with the first to fourth specific examples illustrated in Figs. 9A to 12C. Fig. 13 illustrates a volume ratio of the polysilicon layer 31, the interface shape between the polysilicon layer 31 and the STI layer 32, a relative ratio of the amount of impurities absorbed by the polysilicon layer 31, a relative ratio of the amount of impurities diffused into the silicon layer 36, and a relative value of a dosage of impurities dosed into the polysilicon layer 31 in the comparative example and the first to fourth specific examples.

Fig. 13 illustrates the amount of impurities absorbed in the polysilicon layer 31 and the amount of impurities diffused into the silicon layer 36 in a case where the same amount (for example, 100) of impurities is dosed in the comparative example and the first to fourth specific examples.

As illustrated in Fig. 13, the volume of the polysilicon layer 31 increases in the order of the comparative example, the first specific example, the second specific example, the third specific example, and the fourth specific example. Furthermore, the amount of impurities absorbed in the polysilicon layer 31 increases in the order of the comparative example, the first specific example, the second specific example, the third specific example, and the fourth specific example. Moreover, the amount of impurities diffused into the silicon layer 36 decreases in the order of the comparative example, the first specific example, the second specific example, the third specific example, and the fourth specific example.

As can be seen from Fig. 13, as the volume of the polysilicon layer 31 increases, diffusion of the impurities into the silicon layer 36 can be further suppressed.

From the viewpoint of increasing the volume of the polysilicon layer 31, a length L1 (see Fig. 7B) of the protrusion 31p of the polysilicon layer 31 in the stacking direction is desirably 10 nm or more, for example. Furthermore, from the viewpoint of suppressing the diffusion of impurities into the silicon layer 36, a width L2 (see Fig. 7B) of the STI layer 32 disposed between the sidewall portion of the protrusion 31p and the silicon layer 36 is desirably 20 nm or more, for example.

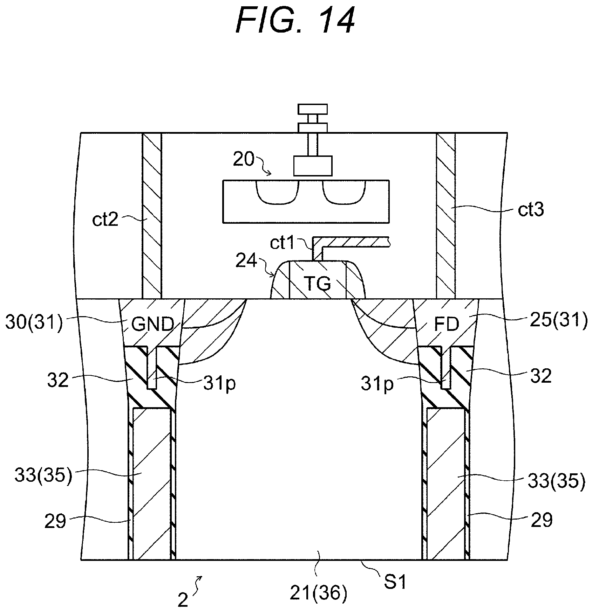

Fig. 4 illustrates an example in which the boundary layer 33 including the polysilicon layer 34 is disposed on the light incident surface S1 side of the STI layer 32, but the boundary layer 33 may be a fixed charge layer 35 instead of the polysilicon layer 34. Fig. 14 is a cross-sectional view of the pixel 2 including the boundary layer 33 having the fixed charge layer 35. In Fig. 4, the boundary layer 33 bonded to the STI layer 32 has a two-layer structure including the fixed charge layer 35 and an insulating layer 29. The fixed charge is a charge having the same polarity as a read charge. Since a charge having a polarity opposite to the fixed charge is induced in the fixed charge layer 35, it is possible to suppress generation of a noise charge having the same polarity as the read charge in the vicinity of the pixel boundary. As a material of the fixed charge layer 35, for example, Hf (hafnium), Ta (tantalum), Ti (titanium), or the like is used.

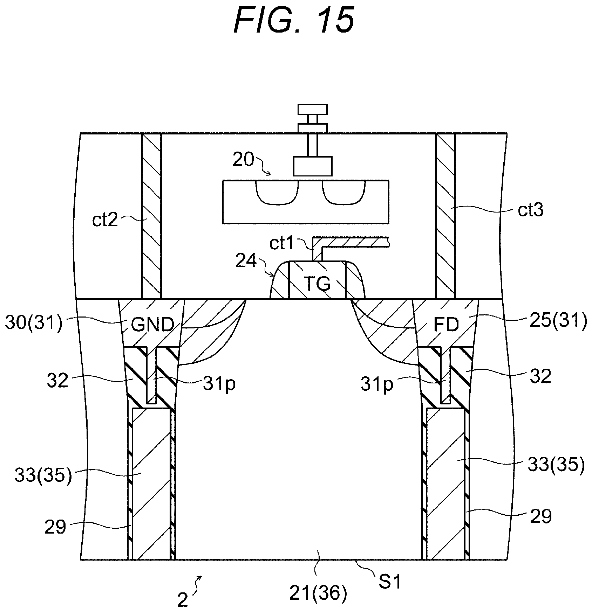

Figs. 4 and 14 illustrate examples in which the end portion of the protrusion 31p of the polysilicon layer 31 on the light incident surface S1 side is provided inside the STI layer 32. However, as illustrated in Fig. 15, the end portion of the protrusion 31p may extend to the vicinity of the boundary region between the STI layer 32 and the boundary layer 33.

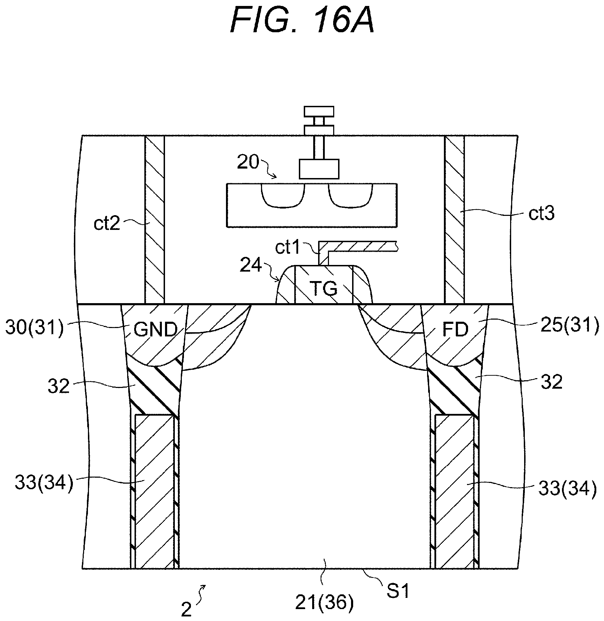

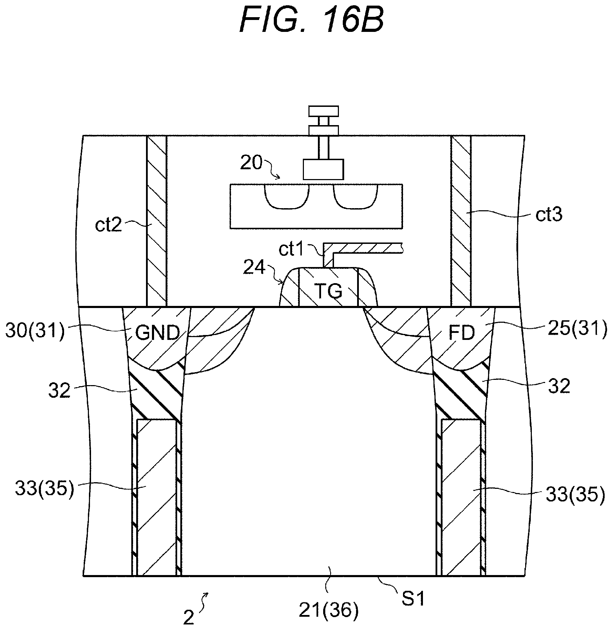

Figs. 16A and 16B are cross-sectional views of the pixel 2 in the case where the interface between the polysilicon layer 31 and the STI layer 32 has a convex shape as illustrated in Fig. 11. Fig. 16A illustrates an example in which the boundary layer 33 includes the polysilicon layer 34, and Fig. 16B illustrates an example in which the boundary layer 33 includes the fixed charge layer 35.

Since the interface between the polysilicon layer 31 and the STI layer 32 in Figs. 16A and 16B has a convex shape, it is possible to increase the volume of the polysilicon layer 31 and to reduce the amount of impurities diffused into the silicon layer 36 as compared with the case of a flat surface.

As described above, in the first embodiment, the polysilicon layer 31 and the STI layer (insulating layer) 32 are formed along the boundary region of the photoelectric conversion unit 21, and the interface between the polysilicon layer 31 and the STI layer 32 has a convex shape in the light incident surface S1 direction. Thereby, it is possible to increase the volume of the polysilicon layer 31 as compared with the case where the interface between the polysilicon layer 31 and the STI layer 32 is a flat surface. The polysilicon layer 31 is doped with impurities for being made conductive, but much of the doped impurities are absorbed by the polysilicon layer 31. Therefore, as the volume of the polysilicon layer 31 is larger, and the impurities diffused from the sidewall portions of the polysilicon layer 31 and the STI layer 32 into the silicon layer 36 where the photoelectric conversion unit 21 is disposed can be suppressed. Thereby, the electric field does not change sharply in the vicinity of the pixel boundary of the photoelectric conversion unit 21, and the electric field design of the photoelectric conversion unit 21 becomes easy.

### (Second Embodiment)

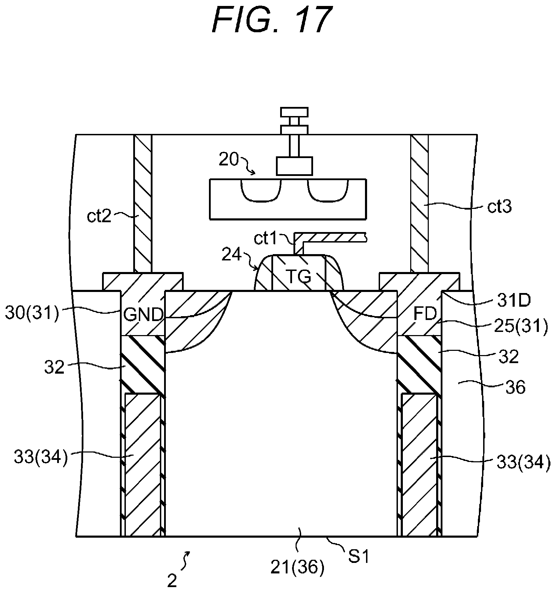

Fig. 17 is a cross-sectional view of one pixel 2 of a photodetection device 1 according to a second embodiment. In Fig. 17, components common to those in Fig. 4 are denoted by the same reference numerals, and differences will be mainly described below.

In the pixel 2 in Fig. 17, a cross-sectional structure of a polysilicon layer 31 and an insulating layer (STI layer) 32 in a boundary region is different from that in Fig. 4. In the boundary region of Fig. 17, at least a part of the polysilicon layer 31 is disposed so as to be in contact with a silicon layer 36, similarly to the boundary region of Fig. 4. The polysilicon layer 31 in Fig. 17 has a step portion 31D in contact with the silicon layer 36. The step portion 31D indicates that the polysilicon layer 31 has a discontinuous sidewall surface. In the example of Fig 17, the polysilicon layer 31 has two discontinuous sidewall surfaces. A corner connecting a surface connecting the two discontinuous sidewall surfaces and each sidewall surface may have an acute angle or may be rounded. Note that the silicon layer 36 is a layer in which a photoelectric conversion unit 21 is disposed.

In the example of Fig. 17, the step portion 31D of the polysilicon layer 31 is disposed along an end surface of the silicon layer 36 on a surface side opposite to a light incident surface S1. That is, a horizontal length of the polysilicon layer 31 above the end face of the silicon layer 36 is longer than the horizontal length of the polysilicon layer 31 below the end face of the silicon layer 36.

The sidewall surface of the polysilicon layer 31 and the sidewall surface of the insulating layer 32 are flush with each other, and both sidewall surfaces are disposed so as to be in contact with the silicon layer 36.

A boundary layer 33 is disposed closer to the light incident surface side than the insulating layer 32 in the boundary region of Fig. 17, similarly to Fig. 4. The boundary layer 33 includes a polysilicon layer 34 or a fixed charge layer. A negative bias voltage is applied to the boundary layer 33.

As described above, the photodetection device 1 of Fig. 17 is different from the photodetection device 1 of Fig. 4 in that the sidewall surface of the polysilicon layer 31 and the sidewall surface of the insulating layer 32 in the boundary region are brought into contact with the silicon layer 36.

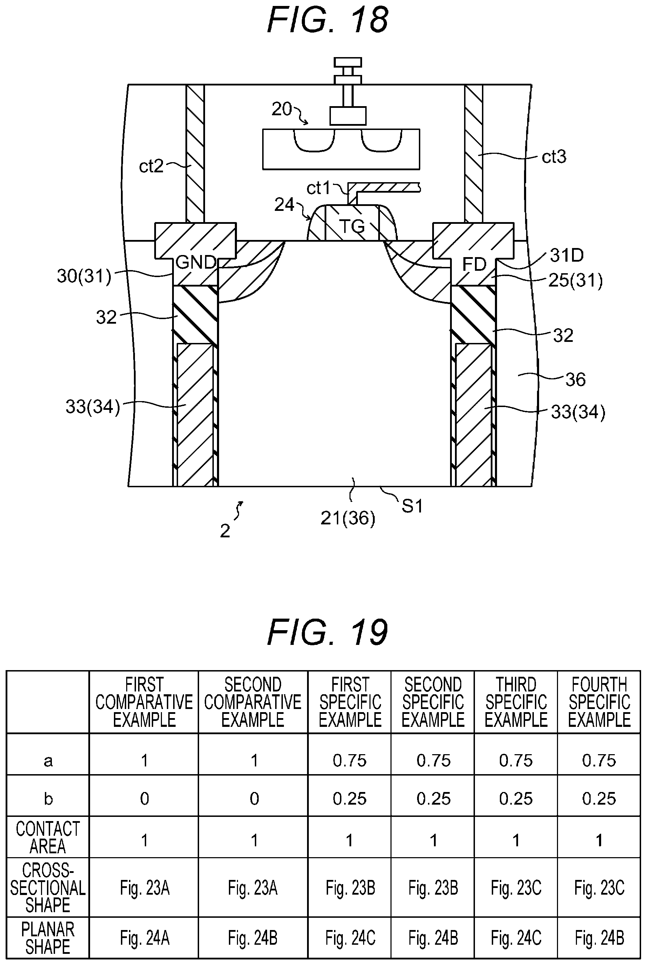

Fig. 18 is a cross-sectional view of one pixel 2 of the photodetection device 1 according to a modification of the second embodiment. In Fig. 18, components common to those in Fig. 17 are denoted by the same reference numerals, and differences will be mainly described below.

The photodetection device 1 of Fig. 18 is different from that of Fig. 17 in the structure of the step portion 31D of the polysilicon layer 31 in the boundary region. The step portion 31D in Fig. 18 is disposed closer to the light incident surface S1 than the end surface of the silicon layer 36 on the surface side opposite to the light incident surface S1. That is, in Fig. 18, the horizontal length of the polysilicon layer 31 between the step portion 31D and the end surface of the silicon layer 36 is longer than the horizontal length of the polysilicon layer 31 on the light incident surface side with respect to the step portion 31D. The sidewall surface of the polysilicon layer 31 and the sidewall surface of the insulating layer 32 on the light incident surface side with respect to the step portion 31D are flush with each other, and both sidewall surfaces are disposed so as to be in contact with the silicon layer 36.

The cross-sectional structure of the boundary region of each pixel 2 in the photodetection device 1 according to the second embodiment is not necessarily limited to that illustrated in Fig. 17 or 18, and various modifications are assumed.

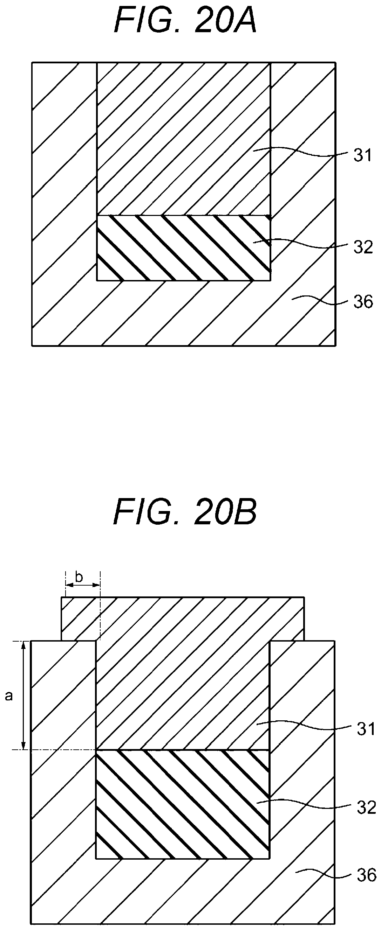

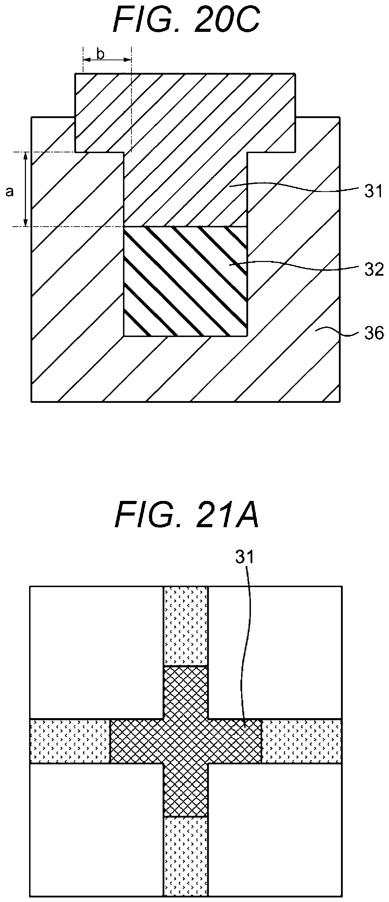

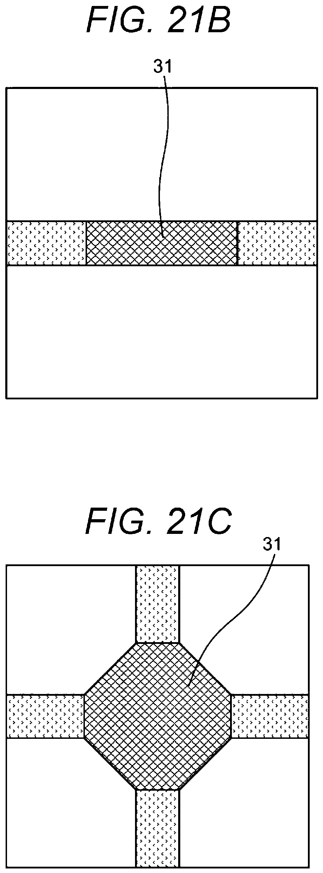

Fig. 19 is a table illustrating characteristics of representative shapes of the photodetection device 1 according to the second embodiment. Fig. 19 illustrates characteristics of the shapes of the photodetection device 1 according to first and second comparative examples and first to fourth specific examples. Fig. 20A is a view illustrating the cross-sectional structure of the boundary region according to the first and second comparative examples. Fig. 20B is a view illustrating the cross-sectional structure of the boundary region according to the first and second specific examples. Fig. 20C is a view illustrating the cross-sectional structure of the boundary region according to the third and fourth specific examples. Fig. 21A is a plan view of the boundary region according to the first comparative example, and illustrates an example of a cross shape. Fig. 21B is a plan view of the boundary region according to the second comparative example, the second specific example, and the fourth specific example, and illustrates an example of a rectangular shape. Fig. 21C is a plan view of the boundary region according to the first specific example and the third specific example, and illustrates an example of an octagonal shape.

A parameter a in Fig. 19 is a parameter related to the length of the polysilicon layer 31 in a depth direction from the end face of the silicon layer 36 on the surface side opposite to the light incident surface S1. A parameter b is a parameter related to the horizontal length of the polysilicon layer 31 at the step portion 31D. A contact area is an area of a contact interface between the polysilicon layer 31 and the insulating layer 32.

In Fig. 19, values of the parameters a and b are represented by a ratio in which a sum of the lengths of the parameters a and b is 1. The values of the parameters a and b are an example, and are not limited to the values in Fig. 19. Furthermore, Fig. 19 illustrates characteristics of the cross-sectional shapes and the planar shapes of the boundary regions according to the first to fourth specific examples, but the cross-sectional shape and the planar shape of the boundary region of the photodetection device 1 according to the second embodiment are not limited to those illustrated in Fig. 19.

As described above, in the second embodiment, since the step portion 31D is provided in the polysilicon layer 31 in the boundary region so that the step portion 31D is in contact with the silicon layer 36, the area of the polysilicon layer 31 in contact with the silicon layer 36 can be increased. Thereby, the volume of the polysilicon layer 31 increases, and the impurities diffused from the sidewall portions of the polysilicon layer 31 and the insulating layer (STI layer) 32 into the silicon layer 36 where the photoelectric conversion unit 21 is disposed can be suppressed. Therefore, an electric field does not change sharply near the boundary of the pixel 2 of the photoelectric conversion unit 21, and electric field design of the photoelectric conversion unit 21 becomes easy.

### (Third Embodiment)

A third embodiment is provided with a vertical electrode extending from a transfer electrode in a depth direction of a silicon layer 36 in a pixel 2, and efficiently collects a photoelectrically converted charge using the vertical electrode and easily transfers the charge from the transfer electrode and the vertical electrode to a floating diffusion layer 25.

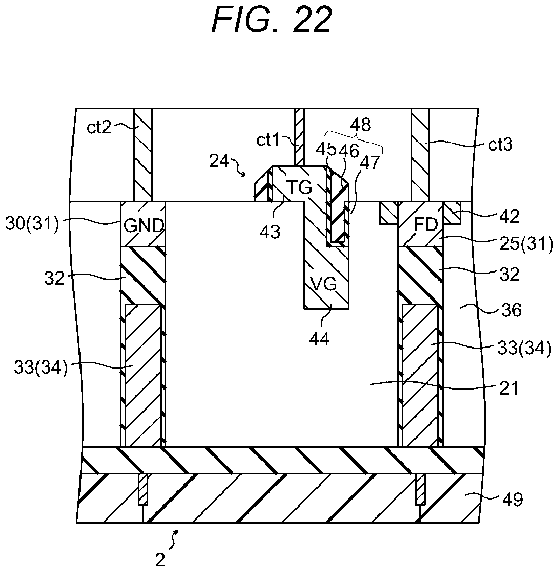

Fig. 22 is a cross-sectional view of one pixel 2 of a photodetection device 1 according to the third embodiment. In Fig. 22, components common to those in Fig. 4 are denoted by the same reference numerals, and differences will be mainly described below.

The pixel 2 in Fig. 22 includes the floating diffusion layer 25 (floating gate) or a ground layer 30 disposed along a boundary region of the pixel 2. The floating diffusion layer 25 and the ground layer 30 include a polysilicon layer 31, and an insulating layer (STI layer) 32 is disposed on a light incident surface side with respect to the polysilicon layer 31. Furthermore, a boundary layer 33 is disposed on the light incident surface side with respect to the insulating layer 32 in the boundary region. The boundary layer 33 includes a polysilicon layer 34 or a fixed charge layer.

A sidewall surface of the polysilicon layer 31 constituting the floating diffusion layer 25 and a sidewall surface of the insulating layer 32 are flush with each other and are in contact with the silicon layer 36. For example, N-type impurities are implanted into the polysilicon layer 31. The N-type impurities are diffused from the sidewall surface of the polysilicon layer 31 toward the silicon layer 36 to form an N-type diffusion region 42. The N-type diffusion region 42 has a self-alignment structure that diffuses from the sidewall surface of the polysilicon layer 31 to the silicon layer 36 in the boundary region. In the present specification, the N-type diffusion region 42 disposed in the sidewall portion of the floating diffusion layer 25 is referred to as a side contact structure.

A transfer electrode 43 is disposed on an end surface of the silicon layer 36 on a surface side opposite to a light incident surface S1, and a vertical electrode 44 extends from the transfer electrode 43 in the depth direction of the silicon layer 36. A sidewall portion 48 is disposed along sidewall surfaces of the transfer electrode 43 and the vertical electrode 44. The sidewall portion 48 includes a silicon nitride layer 46. More specifically, the sidewall portion 48 has a laminated structure in which a silicon oxide film 45, a silicon nitride film 46, and a silicon oxide film 47 are stacked from the sidewall surfaces of the transfer electrode 43 and the vertical electrode 44 toward the N-type diffusion region 42.

The sidewall portion 48 is disposed to face an N-type impurity region of the floating diffusion layer 25. Thereby, a charge transferred to the transfer electrode 43 via the vertical electrode 44 is transferred to the floating diffusion layer 25 via the sidewall portion 48 and the N-type impurity region.

By disposing the sidewall portion 48 on the transfer electrode 43 and the vertical electrode 44, an electric field near a corner portion of the transfer electrode 43 and the vertical electrode 44 can be relaxed, and electric field design of the silicon layer 36 becomes easy and the pixel 2 can be downsized.

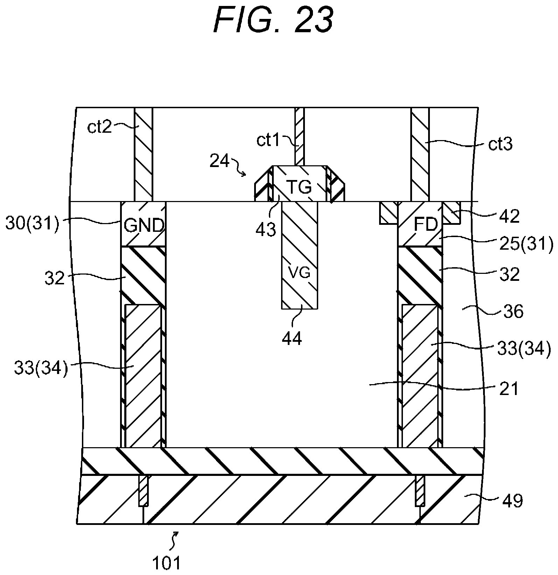

Fig. 23 is a sectional view of a pixel 101 according to a comparative example. The sidewall portion 48 is not disposed near the corner portion of the transfer electrode 43 and the vertical electrode 44 in Fig. 23. For this reason, the electric field of the sidewall surface of the vertical electrode 44 becomes large, the electric field design of the silicon layer 36 becomes difficult, and the pixel 2 cannot be downsized.

The pixel 2 in Fig. 22 is assumed to employ a manufacturing method in which a trench (STI) is formed in the silicon layer 36 from the surface side opposite to the light incident surface S1, and the boundary layer 33, the insulating layer 32, and the polysilicon layer 31 are sequentially formed. On the other hand, a manufacturing method in which a trench is formed in the boundary region from the light incident surface (back surface) side and each layer is formed may be employed.

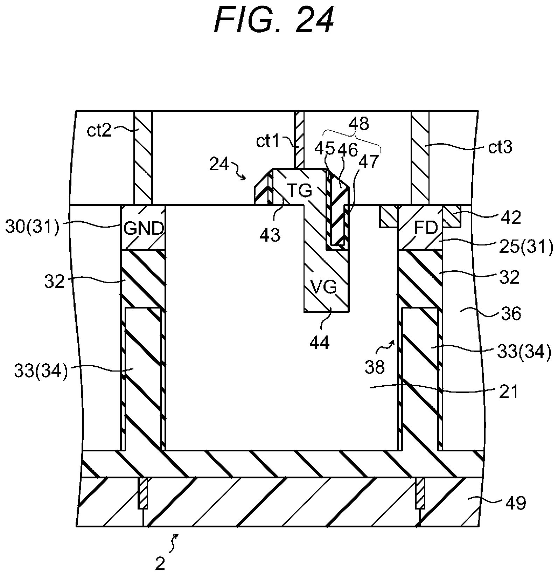

Fig. 24 is a cross-sectional view of the pixel 2 prepared by forming a trench 38 from the light incident surface side. The trench 38 in Fig. 24 is formed so as to penetrate the silicon layer 36 from the light incident surface (back surface) side in the boundary region. In the trench 38, the polysilicon layer 31, the insulating layer (STI layer) 32, and the boundary layer 33 are stacked in this order from the surface side opposite to the light incident surface S1. A color filter layer 49 is disposed on the light incident surface side of the silicon layer 36. Furthermore, an on-chip lens layer (not illustrated) may be disposed on the light incident surface side of the color filter layer 49.

The boundary layer 33 in Fig. 24 may be an insulating layer of SiO₂ or the like, or may include a light shielding member of aluminum (Al), tungsten (W), platinum (Pt), or the like. Furthermore, voids may be included in at least a part of the boundary layer 33. By forming the boundary layer 33 as a light shielding member, it is possible to prevent incidence of light from the adjacent pixel 2 and to improve performance of color mixture prevention.

In the pixel 2 in Fig. 24, the N-type diffusion region 42 is disposed in a self-alignment manner on the sidewall surface of the polysilicon layer 31, similarly to Fig. 22. Furthermore, the transfer electrode 43 is disposed on the end surface of the silicon layer 36 on the surface side opposite to the light incident surface S1, and the vertical electrode 44 is disposed from the transfer electrode 43 in the depth direction of the silicon layer 36. The sidewall portion 48 is disposed along the sidewall surfaces of the transfer electrode 43 and the vertical electrode 44. Thereby, similarly to the pixel 2 in Fig. 22, the electric field near the corner portion between the transfer electrode 43 and the vertical electrode 44 can be relaxed, and the pixel 2 can be downsized.

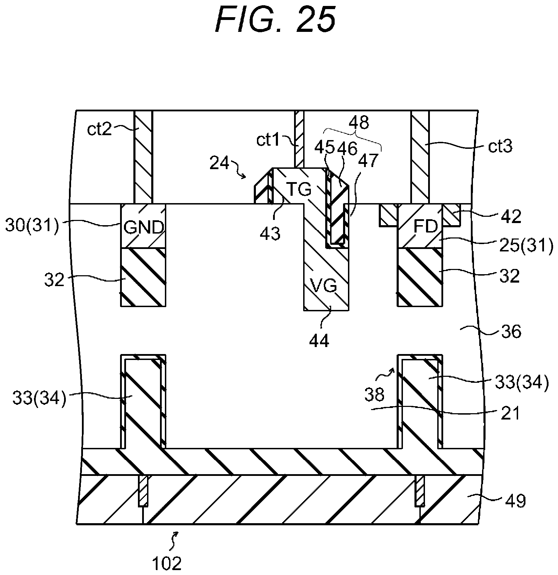

Fig. 25 is a cross-sectional view of a pixel 102 according to a comparative example. In the pixel 102 of Fig. 25, similarly to the pixel 2 of Fig. 24, the trench 38 is formed in the boundary region from the light incident surface side, and the boundary layer 33 is disposed in the trench 38, but the trench 38 does not penetrate the silicon layer 36. For this reason, a region through which light passes is generated between the insulating layer 32 and the boundary layer 33 in the boundary region, and there is a possibility that light from the adjacent pixel 2 is incident. In the pixel 2 of Fig. 24, the trench 38 is formed so as to penetrate the silicon layer 36, and the boundary layer 33 disposed in the trench 38 extends to the depth to contact the insulating layer 32. Thereby, the pixel 2 in Fig. 24 has higher performance of preventing color mixture than the pixel 102 in Fig. 25.

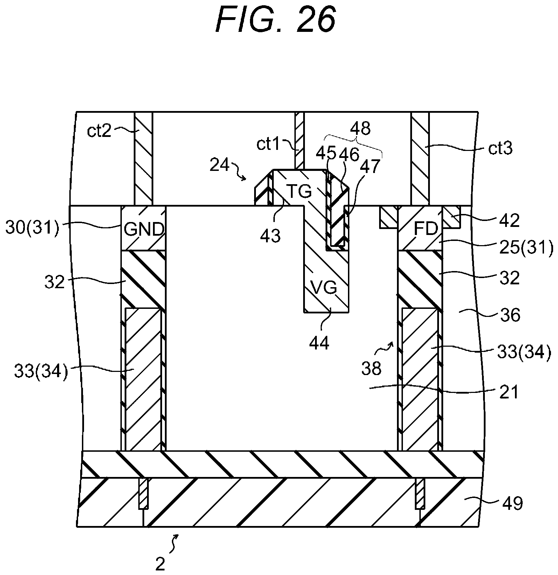

Fig. 26 is a cross-sectional view of the pixel 2 according to a modification of Fig. 24. Fig. 26 is different from Fig. 24 in the structure of the boundary layer 33. The boundary layer 33 in Fig. 26 has, for example, the polysilicon layer 31 or the fixed charge film, and a negative bias voltage is applied thereto. Thereby, pinning on the sidewall surface of the boundary layer 33 can be enhanced, and dark current can be suppressed.

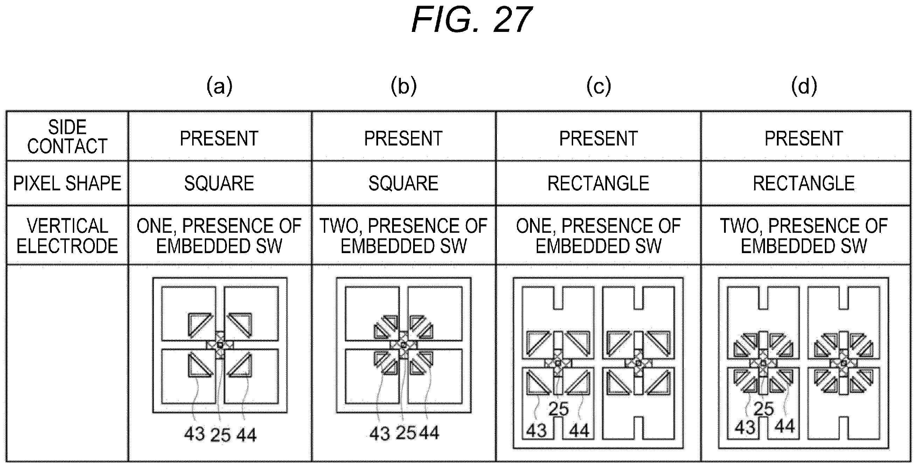

Arrangement location, number, and shape of the vertical electrodes 44 in the pixel 2 are arbitrary, and various modifications are assumed. Fig. 27 is a table summarizing characteristics of a plurality of representative specific examples of the vertical electrode 44. Fig. 27(a) is a plan view of the pixel 2 according to the first specific example. Fig. 27(a) illustrates arrangement locations of the floating diffusion layer 25, the transfer electrode 43, and the vertical electrode 44 in the adjacent four pixels 2. In Fig. 27(a), the transfer electrode 43 and the vertical electrode 44 each having a triangular planar shape are disposed to be shifted in each pixel 2. By disposing the transfer electrode 43 and the vertical electrode 44 slightly shifted, the sidewall portion 48 as illustrated in Fig. 24 can be disposed in a shifted region (offset region). The floating diffusion layer 25 is disposed in the central boundary region of the total of four pixels 2, two in each of vertical and horizontal directions. The transfer electrode 43 and the vertical electrode 44 are symmetrically disposed in each of the four pixels 2 around the floating diffusion layer 25. The floating diffusion layer 25 in Fig. 27(a) has a side contact structure as illustrated in Fig. 24.

Fig. 27(b) is a plan view of the pixel 2 according to the second specific example. In Fig. 27(b), the direction of the transfer electrode 43 and the vertical electrode 44 of each pixel 2 is different from that in Fig. 27(a), but is common to Fig. 27(a) in that the transfer electrode 43 and the vertical electrode 44 of each pixel 2 are symmetrically disposed with respect to the floating diffusion layer 25, and the transfer electrode 43 and the vertical electrode 44 have the sidewall portion 48.

Fig. 27(c) is a plan view of the pixel 2 according to the third specific example. Fig. 27(c) illustrates an example of a phase difference detection pixel 2. The phase difference detection pixel 2 detects a phase difference using a left (L) pixel and a right (R) pixel as a set. Fig. 27(c) illustrates an example in which two phase difference detection pixels 2 share the floating diffusion layer 25. This example is common to Fig. 27(a) in that the transfer electrode 43 and the vertical electrode 44 are symmetrically disposed with respect to the floating diffusion layer 25, and the transfer electrode 43 and the vertical electrode 44 have the sidewall portion 48.

Fig. 27(d) is a plan view of the pixel 2 according to the fourth specific example. Fig. 27(d) illustrates an example of the phase difference detection pixel 2 similarly to Fig. 27(c), and the direction of the transfer electrode 43 and the vertical electrode 44 is different from that in Fig. 27(c).

Figs. 27(a) to 27(d) illustrate the examples in which the planar shapes of the transfer electrode 43 and the vertical electrode 44 are triangular, but the planar shapes of the transfer electrode 43 and the vertical electrode 44 are arbitrary. Furthermore, the numbers of transfer electrodes 43 and vertical electrodes 44 disposed in one pixel 2 are also arbitrary.

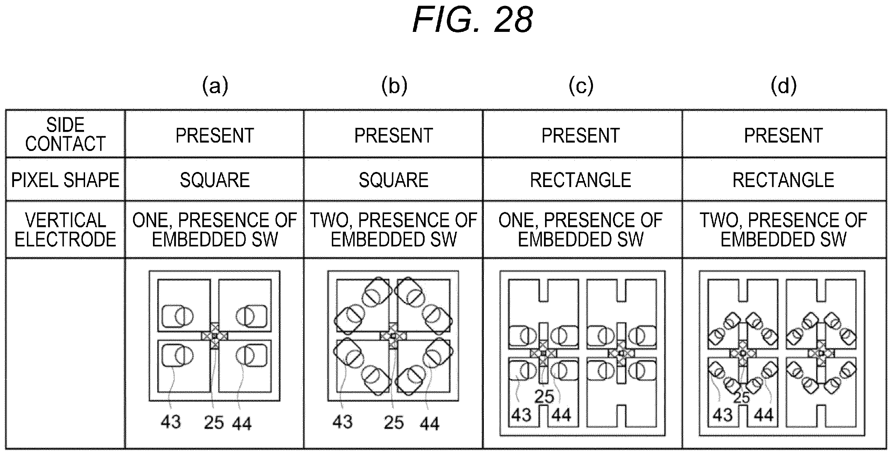

Fig. 28 is a table summarizing characteristics of a plurality of representative modifications of the vertical electrode 44. Fig. 28(a) is a plan view of the pixel 2 according to the first modification. In Fig. 28(a), the floating diffusion layer 25 is disposed at the center of four adjacent pixels 2. The floating diffusion layer 25 has a side contact structure. In each pixel 2, the transfer electrode 43 having a square planar shape and the vertical electrode 44 having a circular planar shape are disposed to be shifted from each other, and the sidewall portion 48 is disposed on the sidewall surfaces of the transfer electrode 43 and the vertical electrode 44. The transfer electrode 43 and the vertical electrode 44 of each pixel 2 are symmetrically disposed with respect to the floating diffusion layer 25.

Fig. 28(b) is a plan view of the pixel 2 according to the second modification. Each pixel 2 in Fig. 28(b) has two transfer electrodes 43 and two vertical electrodes 44. The two transfer electrodes 43 in the pixel 2 are disposed in a diagonal direction, and the two vertical electrodes 44 are disposed to face each other.

Fig. 28(c) is a plan view of the pixel 2 according to the third modification. Fig. 28(c) illustrates an example of the phase difference detection pixel 2. Figs. 27(c) and 27(d) are common in that the two phase difference detection pixels 2 share the floating diffusion layer 25. Each phase difference detection pixel 2 is symmetrically disposed with respect to the floating diffusion layer 25.

Fig. 28(d) is a plan view of the pixel 2 according to the fourth modification. Fig. 28(d) illustrates an example of the phase difference detection pixel 2, similarly to Fig. 28(c). In Fig. 28(d), twice as many transfer electrodes 43 and vertical electrodes 44 as those in Fig. 28(c) are disposed in each pixel 2. This example is common to Fig. 28(c) in that each of the phase difference detection pixels 2 is symmetrically disposed with respect to the floating diffusion layer 25.

As illustrated in Figs. 27(a) to 27(d) and Figs. 28(a) to 28(d), various variations can be assumed in the planar shapes, the arrangement locations, the numbers of arrangements, and the arrangement directions of the transfer electrode 43 and the vertical electrode 44. In the silicon layer 36 in which the vertical electrode 44 is formed, a generation ratio of unbonded dangling bonds is different depending on a plane orientation, and a generation frequency of dark current is also different. Therefore, the plane orientation of silicon may be taken into consideration when forming the boundary layer 33 with the vertical electrode 44.

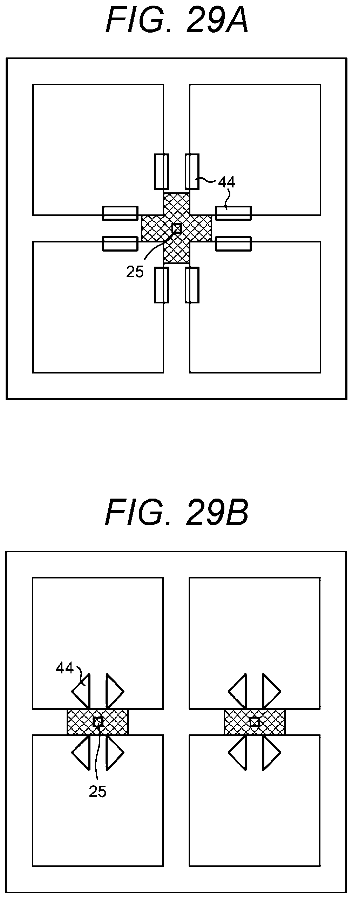

Fig. 29A is a plan view of the pixel 2 according to the fifth modification. Fig. 29A illustrates an example in which the plane orientations of the vertical electrode 44 and the boundary layer 33 are matched with each other. Fig. 29A illustrates an example in which the planar shape of the vertical electrode 44 is rectangular. In Fig. 29A, both the plane orientation of the vertical electrode 44 and the plane orientation of the boundary layer 33 are set to a (100) plane. The (100) plane has a smaller ratio of dangling bonds and a smaller generation ratio of dark current than other plane orientations, for example, a (110) plane. Therefore, by setting both the plane orientation of the vertical electrode 44 and the plane orientation of the boundary layer 33 to the (100) plane, dark current in the boundary region can be suppressed.

Fig. 29B is a plan view of the pixel 2 according to the sixth modification. Fig. 29B is different from Fig. 29A in that the planar shape of the vertical electrode 44 is triangular, but is common to Fig. 29A in that the plane orientations of the vertical electrode 44 and the boundary layer 33 are set to, for example, the (100) plane.

As described above, in the third embodiment, the N-type diffusion region 42 diffused in a self-alignment manner from the floating diffusion layer 25 including the polysilicon layer 31 disposed in the boundary region of the pixel 2 to the periphery is provided, the vertical electrode 44 extending in the depth direction from the transfer electrode 43 disposed on the end surface of the silicon layer 36 on the surface side opposite to the light incident surface S1 is provided, and the sidewall portion 48 is disposed on the sidewall surfaces of the transfer electrode 43 and the vertical electrode 44. Thereby, the electric field near the corner portion between the transfer electrode 43 and the vertical electrode 44 can be relaxed, and the pixel 2 can be downsized.

### (Fourth Embodiment)

The photoelectric conversion unit 21 and the pixel circuit constituting each pixel 2 of the photodetection device 1 according to the above-described first to third embodiments may be disposed on the same substrate or may be disposed on different substrates.

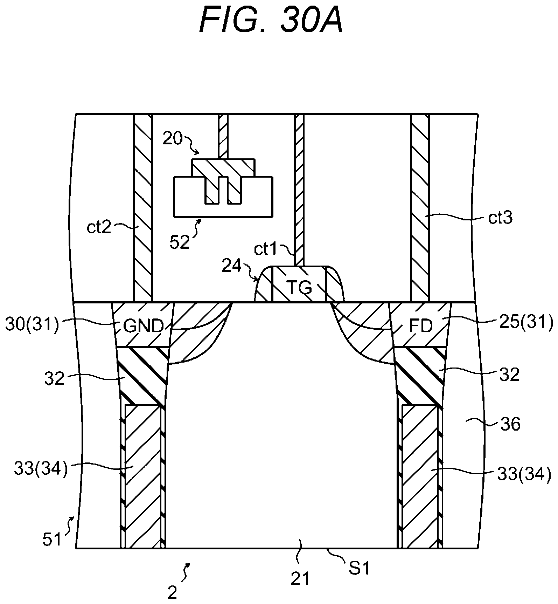

Fig. 30A is a cross-sectional view of one pixel 2 of a photodetection device 1 according to a fourth embodiment. In the pixel 2 in Fig. 30A, a substrate 51 on which a photoelectric conversion unit is disposed and a substrate 52 on which a pixel circuit is disposed are separately provided, and these substrates 51 and 52 are stacked.

A boundary region of the pixel 2 in Fig. 30A has a structure in which a polysilicon layer 31, an insulating layer (STI layer) 32, and a boundary layer 33 are stacked, for example, similarly to Fig. 24. Furthermore, a transfer electrode 43 is disposed on an end surface of a silicon layer 36 on a surface side opposite to a light incident surface S1, and a vertical electrode 44 extends from the transfer electrode 43 in a depth direction of the silicon layer 36. A length of the vertical electrode 44 in the depth direction is arbitrary, and for example, the vertical electrode 44 may extend to a position deeper than an interface between the insulating layer 32 and the boundary layer 33, or the vertical electrode 44 may extend to a position shallower than the above-described interface.

Contacts ct2 and ct3 extending upward are connected to the polysilicon layer 31 in the boundary region. Similarly, a contact ct1 extending upward is connected to the transfer electrode 43.

A pixel 2 transistor is disposed in the pixel circuit. The pixel 2 transistor includes an amplification transistor, a reset transistor, a selection transistor, and the like (not illustrated). The pixel 2 transistor may include a fin gate or a planar gate. A contact ct4 extending upward is connected to the fin gate or the planar gate of the pixel 2 transistor.

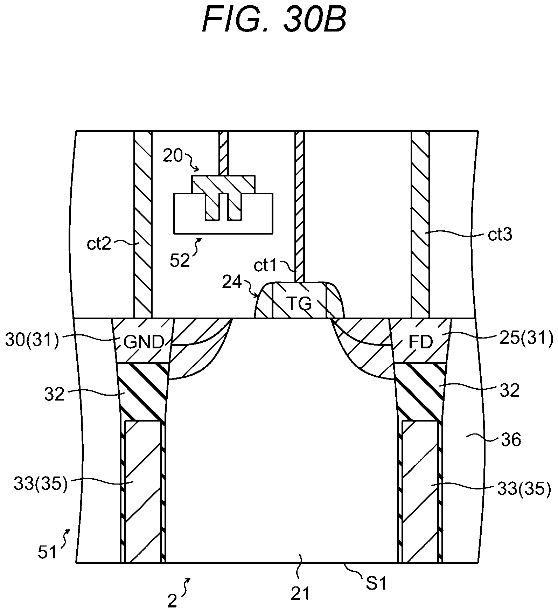

Fig. 30B is a cross-sectional view of the pixel 2 according to a modification of Fig. 30A. In Fig. 30B, the structure of the boundary layer 33 is the same as that in Fig. 26.

Figs. 30A and 30B are merely examples. For example, the polysilicon layer 31 in the boundary region may have a protrusion 31p, similarly to Fig. 4, or may have a convex surface, similarly to Fig. 16A.

Furthermore, the vertical electrode 44 in each pixel 2 of the photodetection device 1 according to the fourth embodiment may have any structure of Figs. 28(a) to 28(d), Figs. 29A to 29D, and Figs. 30A and 30B. Moreover, the vertical electrode 44 is not necessarily required, and may be omitted.

As described above, in the photodetection device 1 according to the fourth embodiment, since the photoelectric conversion unit and the pixel circuit are disposed and stacked on the separate substrates, a volume of the photoelectric conversion unit for each pixel 2 can be increased, and sensitivity can be improved. Furthermore, the pixel 2 can be miniaturized. Moreover, by stacking a plurality of substrates, a chip can be downsized.

### <<Application Examples>>

The technology according to the present disclosure can be applied to various products. For example, the technology according to the present disclosure may also be implemented as a device mounted on any kind of mobile body such as an automobile, an electric automobile, a hybrid electric automobile, a motorcycle, a bicycle, a personal mobility, an airplane, a drone, a ship, a robot, a construction machine, an agricultural machine (tractor), or the like.

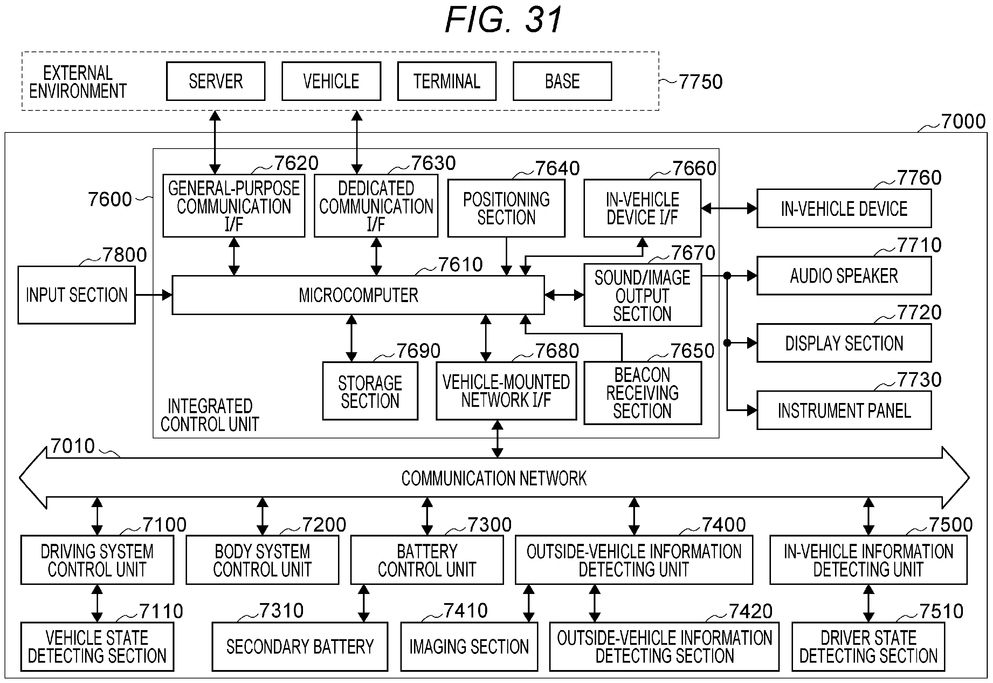

Fig. 31 is a block diagram illustrating an example of schematic configuration of a vehicle control system 7000 as an example of a mobile body control system to which the technology according to an embodiment of the present disclosure can be applied. The vehicle control system 7000 includes a plurality of electronic control units connected to each other via a communication network 7010. In the example illustrated in Fig. 31, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the plurality of control units to each other may, for example, be a vehicle-mounted communication network compliant with an arbitrary standard such as controller area network (CAN), local interconnect network (LIN), local area network (LAN), FlexRay (registered trademark), or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. In Fig. 31, as a functional configuration of the integrated control unit 7600, a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690 are illustrated. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which a plurality of sensors or devices are integrated.

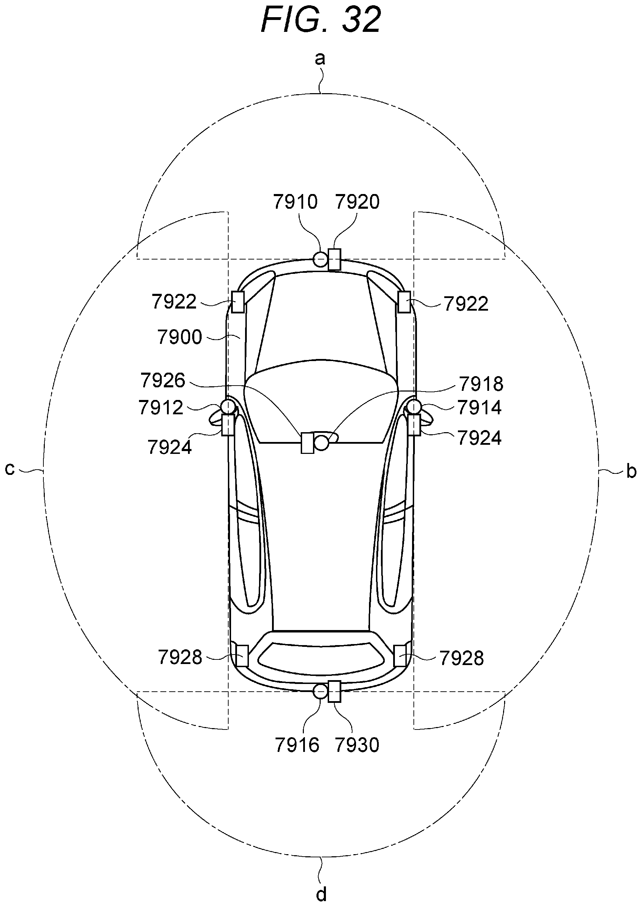

Here, Fig. 32 illustrates an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Note that Fig. 32 illustrates an example of imaging ranges of the respective imaging sections 7910, 7912, 7914, and 7916. An imaging range a represents the imaging range of the imaging section 7910 provided to the front nose. Imaging ranges b and c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Returning to Fig. 31, the description will be continued. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by a plurality of different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magneto-optical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM (registered trademark)), worldwide interoperability for microwave access (WiMAX (registered trademark)), long term evolution (LTE (registered trademark)), LTE-advanced (LTE-A), or the like, or another wireless communication protocol such as wireless LAN (referred to also as wireless fidelity (Wi-Fi (registered trademark)), Bluetooth (registered trademark), or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth (registered trademark), near field communication (NFC), or wireless universal serial bus (WUSB). In addition, the in-vehicle device I/F 7660 may establish wired connection by universal serial bus (USB), high-definition multimedia interface (HDMI (registered trademark)), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example of Fig. 31, an audio speaker 7710, a display section 7720, and an instrument panel 7730 are illustrated as the output device. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Note that at least two control units connected to each other via the communication network 7010 in the example illustrated in Fig. 31 may be integrated into one control unit. Alternatively, each individual control unit may include a plurality of control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and a plurality of control units may mutually transmit and receive detection information via the communication network 7010.

Note that a computer program for implementing each function of the photodetection device 1 according to the present embodiment described with reference to Fig. 1 and the like can be implemented in any of the control units or the like. Furthermore, a computer-readable recording medium in which such a computer program is stored can be provided. The recording medium is, for example, a magnetic disk, an optical disk, a magneto-optical disk, a flash memory, or the like. Furthermore, the computer program described above may be distributed via, for example, a network without using a recording medium.

In the vehicle control system 7000 described above, the photodetection device 1 according to the present embodiment described with reference to Fig. 1 and the like can be applied to the integrated control unit 7600 of the application example illustrated in Fig. 31.

Furthermore, at least some of the components of the photodetection device 1 described with reference to Fig. 1 and the like may be implemented in a module (for example, an integrated circuit module constituted by one die) for the integrated control unit 7600 illustrated in Fig. 31. Alternatively, the photodetection device 1 described with reference to Fig. 1 may be implemented by a plurality of control units of the vehicle control system 7000 illustrated in Fig. 31.

Note that the present technology may have the following configurations.
(1) A photodetection device including:
   a plurality of photoelectric conversion units provided for each pixel and disposed in a silicon layer; and
   a polysilicon layer and an insulating layer stacked in a depth direction of the plurality of photoelectric conversion units from a surface side opposite to a light incident surface of the plurality of photoelectric conversion units along a boundary region of the plurality of photoelectric conversion units, in which
   at least a part of the polysilicon layer is disposed so as to be in contact with the silicon layer.
(2) The photodetection device according to (1), in which the polysilicon layer has a step portion in contact with the silicon layer.
(3) The photodetection device according to (2), in which the step portion is disposed along an end surface of the silicon layer on the surface side opposite to the light incident surface.
(4) The photodetection device according to (2), in which the step portion is disposed on a side closer to the light incident surface than an end surface of the silicon layer on the surface side opposite to the light incident surface.
(5) The photodetection device according to any one of (2) to (4), in which a sidewall surface of the polysilicon layer and a sidewall surface of the insulating layer are disposed so as to be in contact with the silicon layer.
(6) The photodetection device according to (1), in which an interface between the polysilicon layer and the insulating layer has a convex shape in a direction of the light incident surface.
(7) The photodetection device according to (6), in which a part of the polysilicon layer is covered with the insulating layer at the interface.
(8) The photodetection device according to (6) or (7), in which the polysilicon layer has a step portion or a convex surface portion in the direction of the light incident surface at the interface.
(9) The photodetection device according to any one of (6) to (8), in which
   the polysilicon layer includes
   a first region in contact with the silicon layer, and
   a second region bonded to the first region and disposed closer to a light incident surface side than the first region, in which
   the insulating layer is disposed between the second region and the silicon layer.
(10) The photodetection device according to (8) or (9), in which the polysilicon layer has a protrusion extending to a side of the insulating layer at the interface, and an end portion of the protrusion on the light incident surface side is disposed inside the insulating layer.
(11) The photodetection device according to (10), in which the insulating layer is disposed between a sidewall portion of the protrusion and the silicon layer.
(12) The photodetection device according to (10) or (11), in which a length of the protrusion from the interface to the side of insulating layer is 10 nm or more.
(13) The photodetection device according to any one of (10) to (12), in which a width of the insulating layer disposed between a sidewall portion of the protrusion and the silicon layer is 20 nm or more.
(14) The photodetection device according to any one of (1) to (13), in which the polysilicon layer is a conductive layer in conduction with a ground layer or a floating diffusion layer.
(15) The photodetection device according to (14), in which
   two of the polysilicon layers are provided for each of the pixels, and
   one of the polysilicon layers is in conduction with the ground layer, and
   another of the polysilicon layers is in conduction with the floating diffusion layer.
(16) The photodetection device according to (15), in which each of the two polysilicon layers is shared by a plurality of pixels.
(17) The photodetection device according to (16), in which
   the floating diffusion layer is disposed in a boundary region of a first pixel group including a plurality of pixels and is shared by the first pixel group, and
   the ground layer is disposed in a boundary region of a second pixel group including a plurality of pixels different from the first pixel group and is shared by the second pixel group.
(18) The photodetection device according to any one of (14) to (17), in which
   the pixel includes a phase difference detection pixel that detects a phase difference, and
   the floating diffusion layer is shared by a plurality of the phase difference detection pixels that detects a phase difference.
(19) The photodetection device according to any one of (14) to (18), further including:
   a transfer electrode disposed along an end surface of the silicon layer on the surface side opposite to the light incident surface, and configured to transfer a charge photoelectrically converted by the photoelectric conversion unit to the floating diffusion layer; and
   a vertical electrode extending from the transfer electrode in a depth direction of the silicon layer, in which
   the transfer electrode and the vertical electrode include a sidewall portion including an insulating material disposed along a sidewall surface of the polysilicon layer.
(20) The photodetection device according to (19), further including:
   an impurity diffusion region disposed inside the silicon layer from the sidewall surface of the polysilicon layer in the boundary region, in which
   the sidewall portion is disposed to face the impurity diffusion region.
(21) The photodetection device according to (19) or (20), in which a plurality of the vertical electrodes is provided for each of the pixels.
(22) The photodetection device according to any one of (19) to (21), further including:
   a boundary layer including a semiconductor or a conductor and stacked on a light incident surface side of the insulating layer along the boundary region of the plurality of photoelectric conversion units, in which
   a plane orientation in an extending direction of the boundary layer and a plane orientation in an extending direction of the vertical electrode are (100) planes.
(23) The photodetection device according to any one of (1) to (22), further including: a boundary layer including a semiconductor or a conductor stacked on a light incident surface side of the insulating layer along the boundary region of the plurality of photoelectric conversion units.
(24) The photodetection device according to (22) or (23), in which the boundary layer includes a polysilicon layer or a fixed charge layer.
(25) The photodetection device according to (23) or (24), in which the boundary layer is a negative bias layer that induces a positive charge.
(26) The photodetection device according to any one of (22) to (25), in which
   the boundary region is disposed so as to penetrate the silicon layer, and
   the boundary region has a structure in which the boundary layer, the insulating layer, and the polysilicon layer are stacked in this order from the light incident surface side to the surface side opposite to the light incident surface side.

Aspects of the present disclosure are not limited to the above-described individual embodiments, but include various modifications that can be conceived by those skilled in the art, and the effects of the present disclosure are not limited to the above-described contents. That is, various additions, modifications, and partial deletions are possible without departing from the conceptual idea and spirit of the present disclosure derived from the matters defined in the claims and equivalents thereof.

### REFERENCE SIGNS LIST

- 1: Photodetection device
- 2: Pixel
- 3: Pixel array unit
- 4: Vertical driving circuit
- 5: Column signal processing circuit
- 6: Horizontal driving circuit
- 7: Output circuit
- 8: Control circuit
- 9: Pixel driving wiring
- 10: Vertical signal line
- 11: Horizontal signal line
- 12: Semiconductor substrate
- 13: Input/output terminal
- 20: Pixel transistor
- 21: Photoelectric conversion unit (photodiode)
- 24: Transfer transistor
- 25: Floating diffusion layer (floating diffusion)
- 26: Reset transistor
- 27: Amplification transistor
- 28: Selection transistor
- 29: Insulating layer
- 30: Ground layer
- 30a: Conductive layer
- 31: Polysilicon layer
- 31a: First region
- 31b: Second region
- 31p: Protrusion
- 32: STI layer (insulating layer)
- 32: Insulating layer
- 33: Boundary layer
- 34: Polysilicon layer
- 35: Fixed charge layer
- 36: Silicon layer
- 37: SiN layer
- 38: Trench
- 39: Insulating layer
- 40: Void (cavity portion)
- 41: Resist
- 42: N-type diffusion region
- 43: Transfer electrode
- 44: Vertical electrode
- 45: Silicon oxide film
- 46: Silicon nitride layer
- 46: Silicon nitride film
- 47: Silicon oxide film
- 48: Sidewall portion
- 49: Color filter layer
- 51: Substrate
- 52: Substrate
- 100: Photodetection device

## Claims

1. A photodetection device comprising:
a plurality of photoelectric conversion units provided for each pixel and disposed in a silicon layer; and
a polysilicon layer and an insulating layer stacked in a depth direction of the plurality of photoelectric conversion units from a surface side opposite to a light incident surface of the plurality of photoelectric conversion units along a boundary region of the plurality of photoelectric conversion units, wherein
at least a part of the polysilicon layer is disposed so as to be in contact with the silicon layer.

2. The photodetection device according to claim 1, wherein the polysilicon layer has a step portion in contact with the silicon layer.

3. The photodetection device according to claim 2, wherein the step portion is disposed along an end surface of the silicon layer on the surface side opposite to the light incident surface.

4. The photodetection device according to claim 2, wherein the step portion is disposed on a side closer to the light incident surface than an end surface of the silicon layer on the surface side opposite to the light incident surface.

5. The photodetection device according to claim 2, wherein a sidewall surface of the polysilicon layer and a sidewall surface of the insulating layer are disposed so as to be in contact with the silicon layer.

6. The photodetection device according to claim 1, wherein an interface between the polysilicon layer and the insulating layer has a convex shape in a direction of the light incident surface.

7. The photodetection device according to claim 6, wherein a part of the polysilicon layer is covered with the insulating layer at the interface.

8. The photodetection device according to claim 6, wherein the polysilicon layer has a step portion or a convex surface portion in the direction of the light incident surface at the interface.

9. The photodetection device according to claim 6, wherein
the polysilicon layer includes
a first region in contact with the silicon layer, and
a second region bonded to the first region and disposed closer to a light incident surface side than the first region, wherein
the insulating layer is disposed between the second region and the silicon layer.

10. The photodetection device according to claim 8, wherein
the polysilicon layer has a protrusion extending to a side of the insulating layer at the interface, and
an end portion of the protrusion on the light incident surface side is disposed inside the insulating layer.

11. The photodetection device according to claim 10, wherein the insulating layer is disposed between a sidewall portion of the protrusion and the silicon layer.

12. The photodetection device according to claim 10, wherein a length of the protrusion from the interface to the side of insulating layer is 10 nm or more.

13. The photodetection device according to claim 10, wherein a width of the insulating layer disposed between a sidewall portion of the protrusion and the silicon layer is 20 nm or more.

14. The photodetection device according to claim 1, wherein the polysilicon layer is a conductive layer in conduction with a ground layer or a floating diffusion layer.

15. The photodetection device according to claim 14, wherein
two of the polysilicon layers are provided for each of the pixels, and
one of the polysilicon layers is in conduction with the ground layer, and
another of the polysilicon layers is in conduction with the floating diffusion layer.

16. The photodetection device according to claim 15, wherein each of the two polysilicon layers is shared by a plurality of pixels.

17. The photodetection device according to claim 16, wherein
the floating diffusion layer is disposed in a boundary region of a first pixel group including a plurality of pixels and is shared by the first pixel group, and
the ground layer is disposed in a boundary region of a second pixel group including a plurality of pixels different from the first pixel group and is shared by the second pixel group.

18. The photodetection device according to claim 14, wherein
the pixel includes a phase difference detection pixel that detects a phase difference, and
the floating diffusion layer is shared by a plurality of the phase difference detection pixels that detects a phase difference.

19. The photodetection device according to claim 14, further comprising:
a transfer electrode disposed along an end surface of the silicon layer on the surface side opposite to the light incident surface, and configured to transfer a charge photoelectrically converted by the photoelectric conversion unit to the floating diffusion layer; and
a vertical electrode extending from the transfer electrode in a depth direction of the silicon layer, wherein
the transfer electrode and the vertical electrode include a sidewall portion including an insulating material disposed along a sidewall surface of the polysilicon layer.

20. The photodetection device according to claim 19, further comprising:
an impurity diffusion region disposed inside the silicon layer from the sidewall surface of the polysilicon layer in the boundary region, wherein
the sidewall portion is disposed to face the impurity diffusion region.

21. The photodetection device according to claim 19, wherein a plurality of the vertical electrodes is provided for each of the pixels.

22. The photodetection device according to claim 19, further comprising:
a boundary layer including a semiconductor or a conductor and stacked on a light incident surface side of the insulating layer along the boundary region of the plurality of photoelectric conversion units, wherein
a plane orientation in an extending direction of the boundary layer and a plane orientation in an extending direction of the vertical electrode are (100) planes.

23. The photodetection device according to claim 1, further comprising: a boundary layer including a semiconductor or a conductor stacked on a light incident surface side of the insulating layer along the boundary region of the plurality of photoelectric conversion units.

24. The photodetection device according to claim 22, wherein the boundary layer includes a polysilicon layer or a fixed charge layer.

25. The photodetection device according to claim 24, wherein the boundary layer is a negative bias layer that induces a positive charge.

26. The photodetection device according to claim 22, wherein
the boundary region is disposed so as to penetrate the silicon layer, and
the boundary region has a structure in which the boundary layer, the insulating layer, and the polysilicon layer are stacked in this order from the light incident surface side to the surface side opposite to the light incident surface side.
